(19) Europäisches Patentamt / European Patent Office / Office européen des brevets

(11) **EP 1 891 740 B1**

(12) **EUROPEAN PATENT SPECIFICATION**

(45) Date of publication and mention
of the grant of the patent:
**09.01.2019 Bulletin 2019/02**

(51) Int Cl.:
*G10L 19/24* (2013.01)    *G10L 19/02* (2013.01)

(21) Application number: **06848793.3**

(86) International application number:
**PCT/IB2006/003986**

(22) Date of filing: **16.06.2006**

(87) International publication number:
**WO 2007/074401 (05.07.2007 Gazette 2007/27)**

(54) **SCALABLE AUDIO ENCODING AND DECODING USING A HIERARCHICAL FILTERBANK**

SKALIERBARE AUDIOKODIERUNG UND -DEKODIERUNG UNTER VERWENDUNG EINER HIERARCHISCHEN FILTERBANK

CODAGE ET DECODAGE AUDIO ECHELONNABLE UTILISANT UN BANC DE FILTRE HIERARCHIQUE

(84) Designated Contracting States:
**AT BE BG CH CY CZ DE DK EE ES FI FR GB GR HU IE IS IT LI LT LU LV MC NL PL PT RO SE SI SK TR**

(30) Priority: **17.06.2005 US 691558 P**
**12.06.2006 US 452001**

(43) Date of publication of application:
**27.02.2008 Bulletin 2008/09**

(60) Divisional application:
**12160328.6 / 2 479 750**

(73) Proprietor: **DTS(BVI) Limited**
**Road Town Tortola (VG)**

(72) Inventors:
• **SHMUNK, Dmitry V.**
**630052 Russia (RU)**
• **BEATON, Richard J.**
**Burnaby, B.C. V5J 3X6 (CA)**

(74) Representative: **Müller, Wolfram Hubertus**
**Patentanwalt**
**Teltower Damm 15**
**14169 Berlin (DE)**

(56) References cited:
EP-A1- 0 864 146        EP-B1- 1 334 484
WO-A1-2005/001813       JP-A- 11 186 911
US-A- 5 377 302         US-A- 5 394 473
US-A- 5 699 382         US-A- 5 764 805
US-A- 5 774 357         US-A- 5 781 144
US-A- 5 886 276         US-A- 6 058 361
US-A- 6 081 783         US-A- 6 122 338
US-A- 6 144 937         US-A1- 2002 126 691
US-A1- 2002 176 353     US-A1- 2003 016 772
US-A1- 2007 153 731     US-B1- 6 298 322
US-B1- 6 757 658        US-B2- 6 868 114
US-B2- 7 003 451

• **DAUDET L ET AL: "Hybrid representations for audiophonic signal encoding", SIGNAL PROCESSING, ELSEVIER SCIENCE PUBLISHERS B.V. AMSTERDAM, NL, vol. 82, no. 11, 1 November 2002 (2002-11-01), pages 1595-1617, XP004381254, ISSN: 0165-1684, DOI: 10.1016/S0165-1684(02)00304-3**

**Description**

BACKGROUND OF THE INVENTION

Field of the Invention

This invention is related to the scalable encoding of an audio signal and more specifically to methods for performing this data rate scaling in an efficient matter for multichannel audio signals including hierarchical filtering, joint coding of tonal components and joint channel coding of time-domain components in the residual signal.

Description of the Related Art

The main objective of an audio compression algorithm is to create a sonically acceptable representation of an input audio signal using as few digital bits as possible. This permits a low data rate version of the input audio signal to be delivered over limited bandwidth transmission channels, such as the Internet, and reduces the amount of storage necessary to store the input audio signal for future playback. For those applications in which the data capacity of the transmission channel is fixed, and non-varying over time, or the amount, in terms of minutes, of audio that needs to be stored is known in advance and does not increase, traditional audio compression methods fix the data rate and thus the level of audio quality at the time of compression encoding. No further reduction in data rate can be effected without either recoding the original signal at a lower data rate or decompressing the compressed audio signal and then recompressing this decompressed signal at a lower data rate. These methods are not "scalable" to address issues of varying channel capacity, storing additional content on a fixed memory, or sourcing bit streams at varying data rates for different applications.

One technique used to create a bit stream with scalable characteristics, and circumvent the limitations previously described, encodes the input audio signal as a high data rate bit stream composed of subsets of low data rate bit streams These encoded low data rate bit streams can be extracted from the coded signal and combined to provide an output bit stream whose data rate is adjustable over a wide range of data rates. One approach to implement this concept is to first encode data at a lowest supported data rate, then encode an error between the original signal and a decoded version of this lowest data rate bit stream. This encoded error is stored and also combined with the lowest supported data rate bit stream to create a second to lowest data rate bit stream. Error between the original signal and a decoded version of this second to lowest data rate signal is encoded, stored and added to the second to lowest data rate bit stream to form a third to lowest data rate bit stream and so on. This process is repeated until the sum of the data rates associated with bit streams of each of the error signals so derived and the data rate of the lowest supported data rate bit stream is equal to the highest data rate bit stream to be supported. The final scalable high data rate bit stream is composed of the lowest data rate bit stream and each of the encoded error bit streams.

A second technique, usually used to support a small number of different data rates between widely spaced lowest and highest data rates, employs the use of more than one compression algorithm to create a "layered" scalable bit stream. The apparatus that performs the scaling operation on a bit stream coded in this manner chooses, depending on output data rate requirements, which one of the multiple bit streams carried in the layered bit stream to use as the coded audio output. To improve coding efficiency and provide for a wider range of scaled data rates, data carried in the lower rate bit streams can be used by higher rate bit streams to form additional higher quality, higher rate bit streams.

Document DAUDET L ET AL: "Hybrid representations for audiophonic signal encoding", SIGNAL PROCESSING, ELSEVIER SCIENCE PUBLISHERS, vol. 82, no. 11, 1 November 2002, pages 1595-1617, XP004381254, ISSN: 0165-1684, DOI: 10.1016/S0165-1684(02)00304-3, discloses a method in which transient, tonal and stochastic components of an audio signal are estimated and encoded using a strategy that includes transform coding associated with overcomplete representation spaces. Amongst representation spaces, a union of local cosine and dyadic wavelets are used showing good separation properties for structural features of audio signals, their tonal part and transient part, respectively. The separation of these two layers is improved by the use of structured representations. The described approach does not rely on any prior segmentation of the audio signal.

Document US 2002/0176353 A1 describes a method and system or encoding and decoding an input signal in relation to the most perceptually relevant aspects of the input signal. More particularly, a two-dimensional transform is applied to the input signal to produce a magnitude matrix and a phase matrix that can be inverse quantized by a decoder. A first column of coefficients of the magnitude matrix represents a mean spectral density function of the input signal. Relevant aspects of the mean spectral density function are encoded at a beginning of a data packet for a later use by a decoder to recreate the input signal, based on an encoding of the magnitude and phase matrices appended with the rest of the data packet.

## SUMMARY OF THE INVENTION

The invention provides for a method of reconstructing a time-domain output audio signal from an encoded bit stream with the features of claim 1, a decoder for reconstructing a time-domain output audio signal from an encoded bit stream with the features of claim 9, a method of encoding an input audio signal with the features of claim 11, and a scalable bit stream encoder for encoding an input audio signal and forming a scalable bit stream with the features of claim 31. In this context, it is noted that the invention is set forth in the aforementioned independent claims, and that all following occurrences of the word "embodiment(s)", if referring to feature combinations different from those defined by the independent claims, refer to examples which were originally filed but which do not represent embodiments of the presently claimed invention, wherein these examples are still shown for illustrative purposes only.

Accordingly, the present invention provides a method for encoding audio input signals to form a master bit stream that can be scaled to form a scaled bit stream having an arbitrarily prescribed data rate and for decoding the scaled bit stream to reconstruct the audio signals.

This is generally accomplished by compressing the audio input signals and arranging them to form a master bit stream. The master bit stream includes quantized components that are ranked on the basis of their relative contribution to decoded signal quality. The input signal is suitably compressed by separating it into a plurality of tonal and residual components, and ranking and then quantizing the components. The separation is suitably performed using a hierarchical filterbank. The components are suitably ranked and quantized with reference to the same masking function or different psychoacoustic criteria. The components may then be ordered based on their ranking to facilitate efficient scaling. The master bit stream is scaled by eliminating a sufficient number of the low ranking components to form the scaled bit stream having a scaled data rate less than or approximately equal to a desired data rate. The scaled bit stream includes information that indicates the position of the components in the frequency spectrum. A scaled bit stream is suitably decoded using an inverse hierarchical filterbank by arranging the quantized components based on the position formation, ignoring the missing components and decoding the arranged components to produce an output bit stream.

In one embodiment, the encoder uses a hierarchical filterbank to decompose the input signal into a multi-resolution time/frequency representation. The encoder extracts tonal components at each iteration of the HFB at different frequency resolutions, removes those tonal components from the input signal to pass a residual signal to the next iteration of the HFB and than extracts residual components from the final residual signal. The tonal components are grouped into at least one frequency sub-domain per frequency resolution and ranked according to their psychoacoustic importance to the quality of the coded signal. The residual components include time-sample components (e.g. a Grid G) and scale factor components (e.g. grids G0, G1) that modify the time-sample components. The time-sample components are grouped into at least one time-sample sub-domain and ranked according to their contribution to the quality of the decoded signal.

At the decoder, the inverse hierarchical filterbank may be used to extract both the tonal components and the residual components within one efficient filterbank structure. All components are inverse quantized and the residual signal is reconstructed by applying the scale factors to the time samples. The frequency samples are reconstructed and added to the reconstructed time samples to produce the output audio signal. Note the inverse hierarchical filterbank may be used at the decoder regardless of whether the hierarchical filterbank was used during the encoding process.

In an exemplary embodiment, the selected tonal components in a multichannel audio signal are encoded using differential coding. For each tonal component, one channel is selected as the primary channel. The channel number of the primary channel and its amplitude and phase are stored in the bit stream. A bit-mask is stored that indicates which of the other channels include the indicated tonal component, and should therefore be coded as secondary channels. The difference between the primary and secondary amplitudes and phases are then entropy-coded and stored for each secondary channel in which the tonal component is present.

In an exemplary embodiment, the time-sample and scale factor components that make up the residual signal are encoded using joint channel coding (JCC) extended to multichannel audio. A channel grouping process first determines which of the multiple channels may be jointly coded and all channels are formed into groups with the last group possibly being incomplete.

Additional objects, features and advantages of the present invention are included in the following discussion of exemplary embodiments, which discussion should be read with the accompanying drawings. Although these exemplary embodiments pertain to audio data, it will be understood that video, multimedia and other types of data may also be processed in similar manners.

## BRIEF DESCRIPTION OF THE DRAWINGS

Figure 1 is a block diagram illustration of a scalable bit stream encoder using a residual coding topology according to the present invention;

Figures 2a and 2b are frequency and time domain representations of a Shmunk window for use with the hierarchical filterbank;

Figure 3 is an illustration of a hierarchical filterbank for providing a multi-resolution time/frequency representation of an input signal from which both tonal and residual components can be extracted with the present invention;

Figure 4 is a flowchart of the steps associated with the hierarchical filterbank;

Figures 5a through 5c illustrate an 'overlap-add' windowing;

Figure 6 is a plot of the frequency response of hierarchical filterbank;

Figure 7 is a block diagram of an exemplary implementation of a hierarchical analysis filterbank for use in the encoder;

Figures 8a and 8b are a simplified block diagram of a 3-stage hierarchical filterbank and a more detailed block diagram of a single stage;

Figure 9 is a bit mask for extending differential coding of tonal components to multichannel audio;

Figure 10 depicts the detailed embodiment of the residual encoder used in an embodiment of the encoder of the present invention;

Figure 11 is a block diagram for joint channel coding for multichannel audio;

Figure 12 schematically represents a scalable frame of data produced by the scalable bit stream encoder of the present invention;

Figure 13 shows the detailed block diagram of one implementation of the decoder used in the present invention;

Figure 14 is an illustration of an inverse hierarchical filterbank for reconstructing time-series data from both time-sample and frequency components in accordance with the present invention;

Figure 15 is a block diagram of an exemplary implementation of an inverse hierarchical filterbank;

Figure 16 is a block diagram of the combining of tonal and residual components using an inverse hierarchical filterbank in the decoder;

Figures 17a and 17b are a simplified block diagram of a 3-stage inverse hierarchical filterbank and a more detailed block diagram of a single stage;

Figure 18 is a detailed block diagram of the residual decoder;

FIG. 19 is a G1 mapping table;

FIG. 20 is a table of base function synthesis correction coefficients; and

FIGs. 21 and 22 are functional block diagrams of the encoder and decoder, respectively, illustrating an application of the multiresolution time/frequency representation of the hierarchical filterbank in an audio encoder/decoder.

## DESCRIPTION OF EXEMPLARY EMBODIMENTS

The present invention provides a method for compressing and encoding audio input signals to form a master bit stream that can be scaled to form a scaled bit stream having an arbitrarily prescribed data rate and for decoding the scaled bit stream to reconstruct the audio signals. A hierarchical filterbank (HFB) provides a multi-resolution time/frequency representation of the input signal from which the encoder can efficiently extract both the tonal and residual components. For multichannel audio, joint coding of tonal components and joint channel coding of residual components in the residual signal is implemented. The components are ranked on the basis of their relative contribution to decoded signal quality and quantized with reference to a masking function. The master bit stream is scaled by eliminating a sufficient number of the low ranking components to form the scaled bit stream having a scaled data rate less than or approximately equal to a desired data rate. The scaled bit stream is suitably decoded using an inverse hierarchical filterbank by arranging the quantized components based on position information, ignoring the missing components and decoding the arranged components to produce an output bit stream. In one possible application, the master bit stream is stored and than scaled down to a desired data rate for recording on another media or for transmission over a bandlimited channel. In another application, in which multiple scaled bit streams are stored on media, the data rate of each stream is independently and dynamically controlled to maximize perceived quality while satisfying an aggregate data rate constrain on all of the bit streams.

As used herein the terms "Domain", "sub-domain", and "component" describe the hierarchy of scalable elements in the bit stream. Examples will include:

| Domain | Sub-Domain | Component |
|---|---|---|
| Tonal | 1024-point resolution transform (4 sub-frames) | Tonal component (phase/amplitude/position) |
| Residual Scale factor Grids | Grid 1 | Scale factor within Grid 1 |

(continued)

| Domain | Sub-Domain | Component |
|---|---|---|
| Residual Subbands | Set of all time samples in sub-band 3 | Each time sample in subband 3 |

**Scalable Bit Stream Encoder with a Residual Coding Topology**

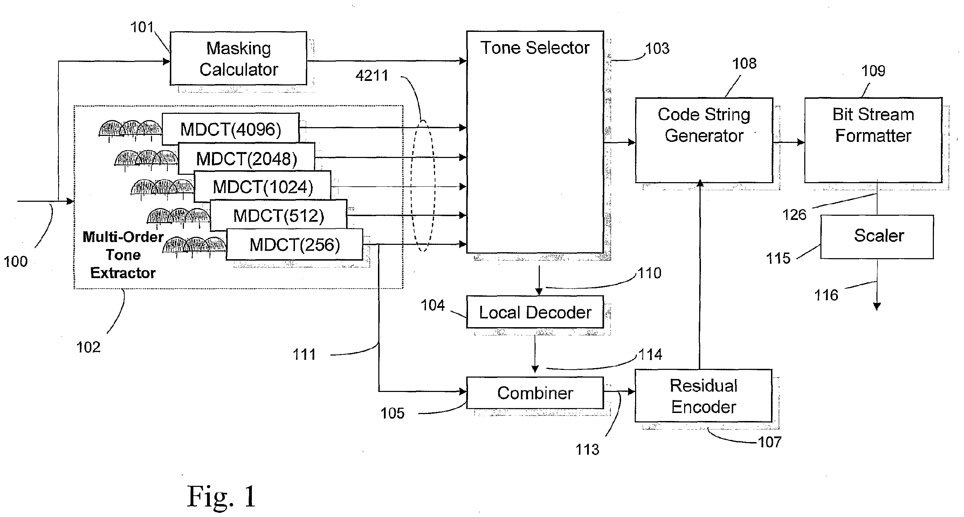

As shown in Figure 1, in an exemplary embodiment a scalable bit stream encoder uses a residual coding topology to scale the bit stream to an arbitrary data rate by selectively eliminating the lowest ranked components from the core (tonal components) and/or the residual (time-sample and scale factor) components. The encoder uses a hierarchical filterbank to efficiently decompose the input signal into a multi-resolution time/frequency representation from which the encoder can efficiently extract the tonal and residual components. The hierarchical filterbank (HFB) described herein for providing the multi-resolution time/frequency representation can be used in many other applications in which such a representation of an input signal is desired. A general description of the hierarchical filterbank and its configuration for use in the audio encoder are described below as well as the modified HFB used by the particular audio encoder.

The input signal 100 is applied to both Masking Calculator 101 and Multi-Order Tone Extractor 102. Masking Calculator 101 analyzes input signal 100 and identifies a masking level as a function of frequency below which frequencies present in input signal 101 are not audible to the human ear. Multi-Order Tone Extractor 102 identifies frequencies present in input signal 101 using, for example, multiple overlapping FFTs or as shown a hierarchical filterbank based on MDCTs, which meet psychoacoustic criteria that have been defined for tones, selects tones according to this criteria, quantizes the amplitude, frequency, phase and position components of these selected tones, and places these tones into a tone list. At each iteration or level, the selected tones are removed from the input signal to pass a residual signal forward. Once complete, all other frequencies that do not meet the criteria for tones are extracted from the input signal and output from Multi-Order Tone Extractor 102, specifically the last stage of the hierarchical filterbank MDCT(256), in the time domain on line 111 as the final residual signal.

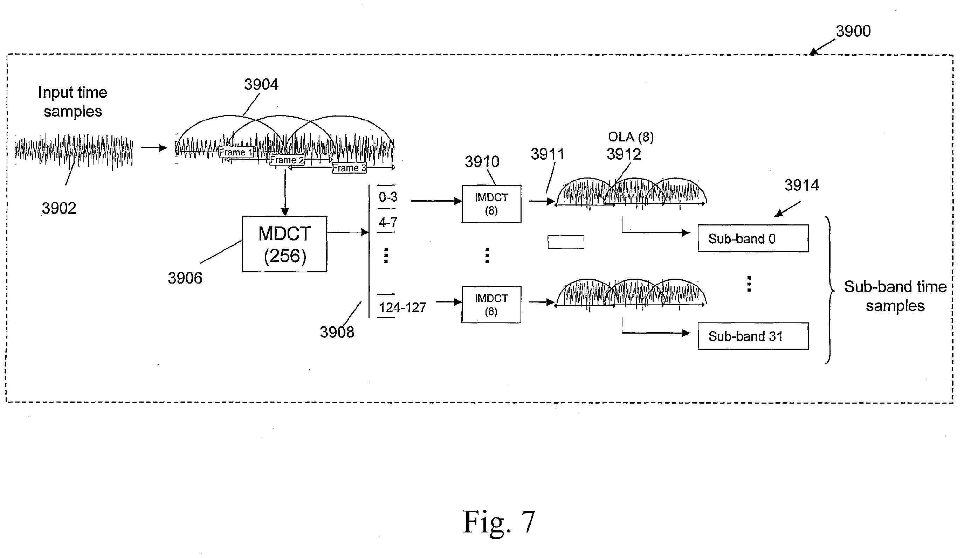

Multi-Order Tone Extractor 102 uses, for example, five orders of overlapping transforms, starting from the largest and working down to the smallest, to detect tones through the use of a base function. Transforms of size: 8192, 4096, 2048, 1024, and 512 are used respectively, for an audio signal whose sampling rate is 44100 Hz. Other transform sizes could be chosen. Figure 7 graphically shows how the transforms overlap each other. The base function is defined by the equations:

$$F(t; A, l, f, \varphi) = A \cdot \frac{1 - \cos(\frac{2\pi}{l} \cdot t)}{2} \cdot \sin(\frac{2\pi}{l} \cdot f \cdot t + \varphi) \qquad t \in [0, l]$$

$$F(t; A, l, f, \varphi) = 0; \qquad t \notin [0, l]$$

where:

$$A_i = Amplitude = (\text{Re}_i \cdot \text{Re}_i + \text{Im}_i \cdot \text{Im}_i) - (\text{Re}_{i+1} \cdot \text{Re}_{i+1} + \text{Im}_{i+1} \cdot \text{Im}_{i+1})$$

$$t = \text{time} \; (t \in N \; \text{being a positive integer value})$$

$$l = \text{transform size as a power of 2} \; (l \in 512, 1024, \ldots, 8192)$$

$$\varphi = \text{phase}$$

$$f = \text{frequency} \qquad (f \in [1, \frac{l}{2}])$$

Tones detected at each transform size are locally decoded using the same decode process as used by the decoder of the present invention, to be described later. These locally decoded tones are phase inverted and combined with the original input signal through time domain summation to form the residual signal that is passed to the next iteration or level of the HFB.

The masking level from Masking Calculator 101 and the tone list from Multi-Order Tone Extractor 102 are inputs to the Tone Selector 103. The Tone Selector 103 first sorts the tone list provided to it from Multi-Order Tone Extractor 102 by relative power over the masking level provided by Masking Calculator 101. It then uses an iterative process to determine which tonal components will fit into a frame of encoded data in the master bit stream. The amount of space available in a frame for tonal components depends on the predetermined, before scaling, data rate of the encoded master bit stream. If the entire frame is allocated for tonal components then no residual coding is performed. In general, some portion of the available data rate is allocated for the tonal components with the remainder (minus overhead) reserved for the residual components.

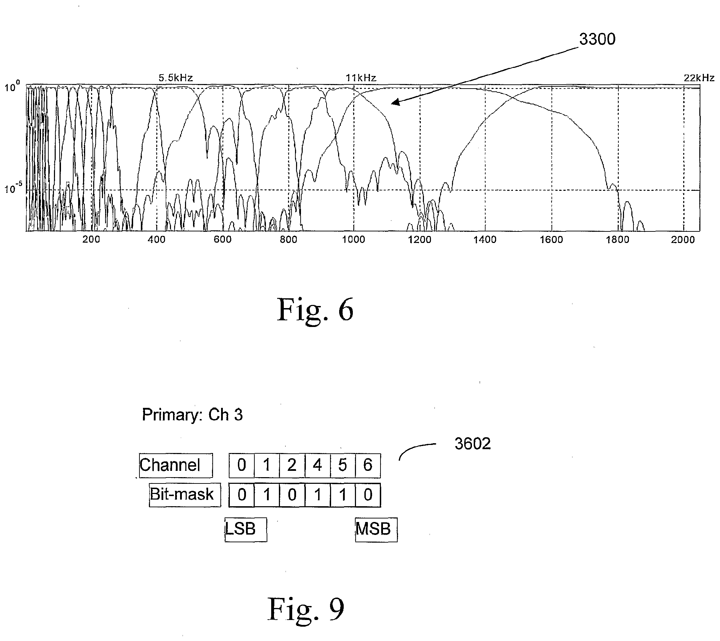

Channel groups are suitably selected for multichannel signals and primary/secondary channels identified within each channel group according to a metric such as contribution to perceptual quality. The selected tonal components are preferably stored using differential coding. For stereo audio, the two-bit field indicates the primary and secondary channels. The amplitude/phase and differential amplitude/phase are stored for the primary and secondary channels, respectively. For multichannel audio the primary channel is stored with its amplitude and phase and a bit-mask (See Figure 9) is stored for all secondary channels with differential amplitude/phase for the included secondary channels. The bit-mask indicates which other channels are coded jointly with the primary channel and is stored in the bit stream for each tonal component in the primary channel.

During this iterative process, some or all of the tonal components that are determined not to fit in a frame may be converted back into the time domain and combined with residual signal 111. If, for example, the data rate is sufficiently high, then typically all of the deselected tonal components are recombined. If, however, the data rate is lower, the relatively strong 'deselected' tonal components are suitably left out of the residual. This has been found to improve perceptual quality at lower data rates. The deselected tonal components represented by signal 110, are locally decoded via Local Decoder 104 to convert them back into the time domain on line 114 and combined with Residual Signal 111 from Multi-Order Tone Extractor 102 in Combiner 105 to form a combined Residual signal 113. Note that the signals appearing on 114 and 111 are both time domain signals so that this combining process can be easily affected. The combined Residual Signal 113 is further processed by the Residual Encoder 107.

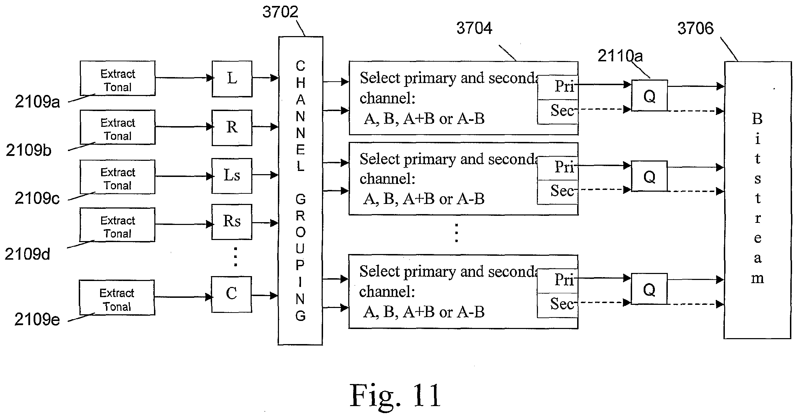

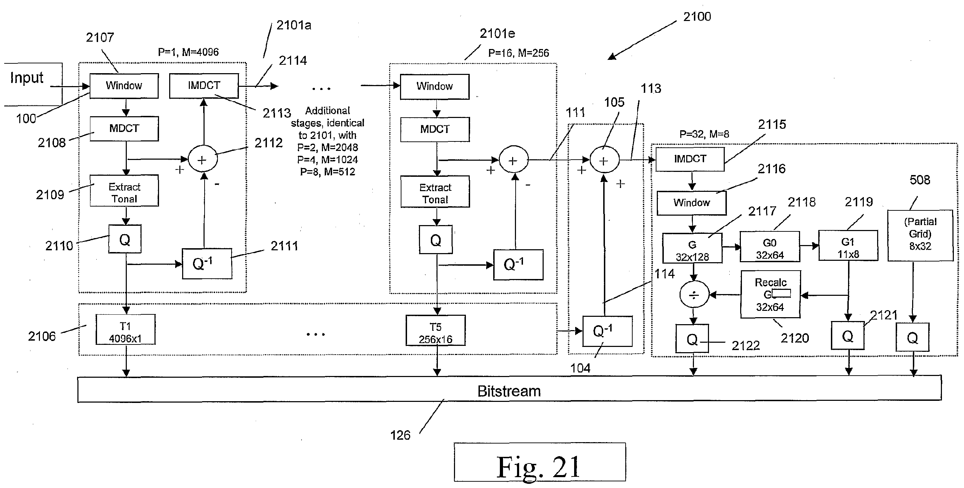

The first action performed by Residual Encoder 107 is to process the combined Residual Signal 113 through a filter bank which subdivides the signal into critically sampled time domain frequency sub-bands. In a preferred embodiment, when the hierarchical filterbank is used to extract the tonal components, these time-sample components can be read directly out of the hierarchical filterbank thereby eliminating the need for a second filterbank dedicated to the residual signal processing. In this case, as shown in Figure 21, the Combiner 104 operates on the output of the last stage of the hierarchical filterbank (MDCT(256)) to combine the 'deselected' and decoded tonal components 114 with the residual signal 111 prior to computing the IMDCT 2106, which produces the sub-band time-samples (See also Fig. 7 steps 3906, 3908 and 3910). Further decomposition, quantization and arrangement of these sub-bands into psychoacoustically relevant order are then performed. The residual components (time-samples and scale factors) are suitably coded using joint channel coding in which the time-samples are represented by a Grid G and the scale factors by Grids G0 and G1 (See Figure 11). The joint coding of the residual signal uses partial grids, applied to channel groups, which represent the ratio of signal energies between primary channel and secondary channel groups. The groups are selected (dynamically or statically) through cross correlations, or other metrics. More than one channel can be combined and used as a primary channel (e.g. L+R primary, C secondary). The use of scale factor grids partial, G0, G1 over time/frequency dimensions is novel as applied to these multichannel groups, and more than one secondary channel can be associated with a given primary channel. The individual grid elements and time samples are ranked by frequency with lower frequencies being ranked higher. The grids are ranked according to bit rate. Secondary channel information is ranked with lower priority than primary channel information.

The Code String Generator 108 takes input from the Tone Selector 103, on line 120, and Residual Encoder 107 on line 122, and encodes values from these two inputs using entropy coding well known in the art into bit stream 124. The Bit Stream Formatter 109 assures that psychoacoustic elements from the Tone Selector 103 and Residual Encoder 107, after being coded through the Code String Generator 108, appear in the proper position in the master bit stream 126. The 'rankings' are implicitly included in the master bit stream by the ordering of the different components.

A scaler 115 eliminates a sufficient number of the lowest ranked encoded components from each frame of the master bit stream, **126** produced by the encoder to form a scaled bit stream 116 having a data rate less than or approximately equal to a desired data rate.

Hierarchical Filterbank

The Multi-Order Tone Extractor 102 preferably uses a 'modified' hierarchical filterbank to provide a multi-resolution time/frequency resolution from which both the tonal components and the residual components can be efficiently extracted. The HFB decomposes the input signal into transform coefficients at successively lower frequency resolutions and back into time-domain sub-band samples at successively finer time scale resolution at each successive iteration. The tonal components generated by the hierarchical filterbank are exactly the same as those generated by multiple overlapping FFTs however the computational burden is much less. The Hierarchical Filterbank addresses the problem of modeling the unequal time/frequency resolution of the human auditory system by simultaneously analyzing the input signal at different time/frequency resolutions in parallel to achieve a nearly arbitrary time/frequency decomposition. The hierarchical filterbank makes use of a windowing and overlap-add step in the inner transform not found in known decompositions. This step and the novel design of the window function allow this structure to be iterated in an arbitrary tree to achieve the desired decomposition, and could be done in a signal-adaptive manner.

As shown in Figure 21, a single-channel encoder 2100 extracts tonal components from the transform coefficients at each iteration 2101a, ..2101e, quantizes and stores the extracted tonal components in a tone list 2106. Joint coding of the tones and residual signals for multichannel signals is discussed below. At each iteration the time-domain input signal (residual signal) is windowed 2107 and an N-point MDCT is applied 2108 to produce transform coefficients. The tones are extracted 2109 from the transform coefficients, quantized 2110 and added to the tone list. The selected tonal components are locally decoded 2111 and subtracted 2112 from the transform coefficients prior to performing the inverse transform 2113 to generate the time-domain sub-band samples that form the residual signal 2114 for the next iteration of the HFB. A final inverse transform 2115 with relatively lower frequency resolution than the final iteration of the HFB is performed on the final combined residual 113 and windowed 2116 to extract the residual components G 2117. As described previously, any 'deselected' tones are locally decoded 104 and combined 105 with residual signal 111 prior to computation of the final inverse transform. The residual components include time-sample components (Grid G) and scale-factor components (Grid G0, G1) that are extracted from Grid G in 2118 and 2119. Grid G is recalculated 2120 and Grid G and G1 are quantized 2121, 2122. The calculation of Grids G, G1 and G0 is described below. The quantized tones on the tone list, Grid G and scale factor Grid G1 are all encoded and placed in the master bit stream. The removal of the selected tones from the input signal at each iteration and the computation of the final inverse transform are the modifications imposed on the HFB by the audio encoder.

A fundamental challenge in audio coding is the modeling of the time/frequency resolution of human perception. Transient signals, such as a handclap, require a high resolution in the time domain, while harmonic signals, such as a horn, require high resolution in the frequency domain to be accurately represented by an encoded bit stream. But it is a well-known principle that time and frequency resolution are inverses of each other and no single transform can simultaneously render high accuracy in both domains. The design of an effective audio codec requires balancing this tradeoff between time and frequency resolution.

Known solutions to this problem utilize window switching, adapting the transform size to the transient nature of the input signal (See K. Brandenburg et al., "The ISO-MPEG-Audio Codec: A Generic Standard for Coding of High Quality Digital Audio", Journal of Audio Engineering Society, Vol. 42, No. 10, October, 1994). This adaptation of the analysis window size introduces additional complexity and requires a detection of transient events in the input signal. To manage algorithmic complexity, the prior art window switching methods typically limit the number of different window sizes to two. The hierarchical filterbank discussed herein avoids this coarse adjustment to the signal/auditory characteristics by representing/processing the input signal by a filterbank which provides multiple time/frequency resolutions in parallel.

There are many filterbanks, known as hybrid filterbanks, which decompose the input signal into a given time/frequency representation. For example, the MPEG Layer 3 algorithm described in ISO/IEC 11172-3 utilizes a Pseudo-Quadrature Mirror Filterbank followed by an MDCT transform in each subband to provide the desired frequency resolution. In our hierarchical filterbank we utilize a transform, such as an MDCT, followed by the inverse transform (e.g. IMDCT) on groups of spectral lines to perform a flexible time/frequency transformation of the input signal.

Unlike hybrid filterbanks, the hierarchical filterbank uses results from two consecutive, overlapped outer transforms to compute 'overlapped' inner transforms. With the hierarchical filterbank it is possible to aggregate more then one transform on top of the first transform. This is also possible with prior-art filterbanks (e.g. tree-like filterbanks), but is impractical due to the fast degradation of frequency-domain separation with increase in number of levels. The hierarchical filterbank avoids this frequency-domain degradation at the expense of some time-domain degradation. This time-domain degradation can, however, be controlled through the proper selection of window shape(s). With the selection of the proper analysis window, the coefficients of the inner transform can also be made invariant to time shifts equal to the size of inner transform (not to the size of the outmost transform as in conventional approaches).

A suitable window W(x) referred to herein as the "Shmunk Window", for use with the hierarchical filterbank is defined by:

$$W^2(x) = \frac{128 - 150\cos\left(\dfrac{2\pi x}{L}\right) + 25\cos\left(\dfrac{6\pi x}{L}\right) - 3\cos\left(\dfrac{10\pi x}{L}\right)}{256}$$

Where x it the time domain sample index (0 < x <= L), and L is the length of the window in samples.

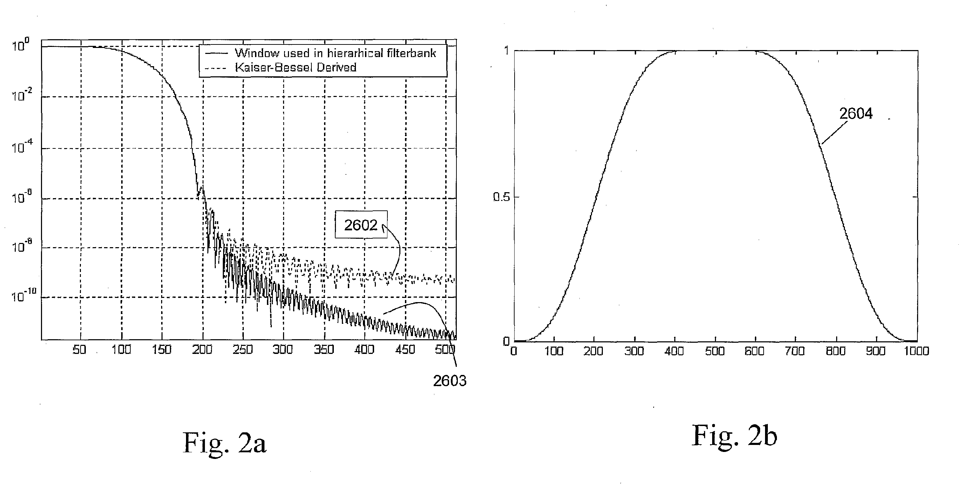

The frequency response 2603 of the Shmunk window in comparison with the commonly used Kaiser-Bessel derived window 2602 is shown in Figure 2a. It can be seen that the two windows are similar in shape but the sidelobe attenuation is greater with the proposed window. The time-domain response 2604 of the Shmunk window is shown in Figure 2b.

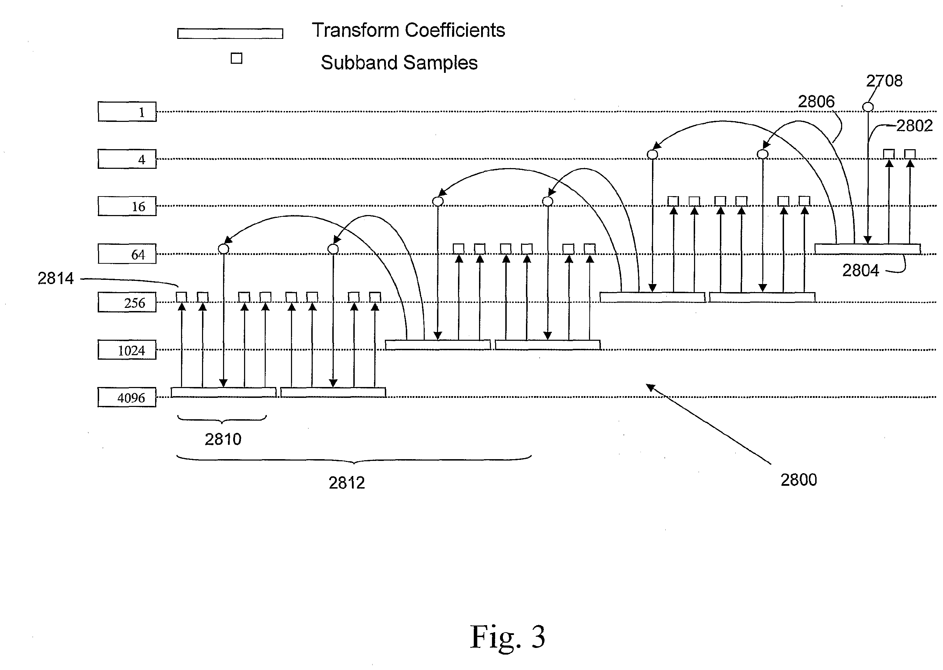

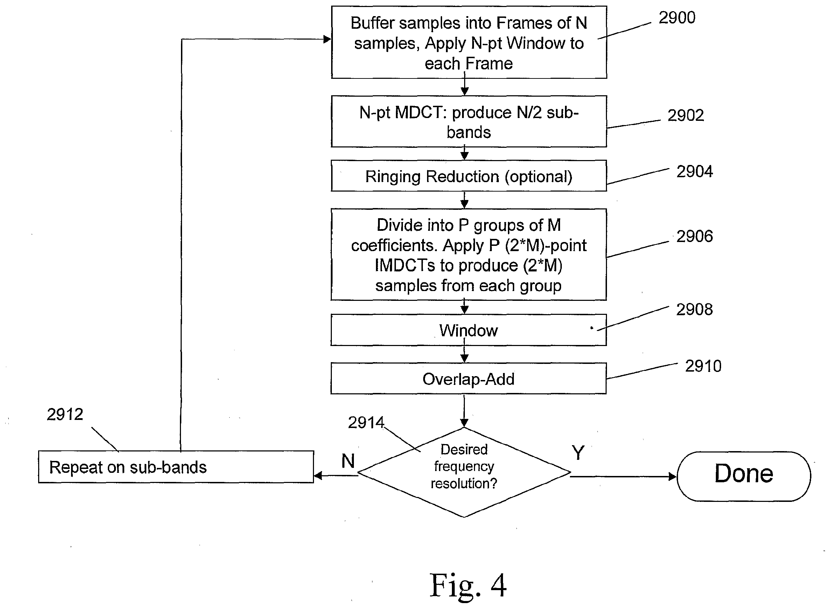

A hierarchical filterbank of general applicability for providing a time/frequency decomposition is illustrated in Figures 3 and 4. The HFB would have to be modified as described above for use in the audio codec. In Figure 3, the number at each dotted line represents the number of equally spaced frequency bins at each level (though not all of these bins are calculated). Downward arrows represent a N-point MDCT transform resulting in N/2 subbands. Upward arrows represent an IMDCT which takes N/8 subbands and transforms them into N/4 time samples within one subband. Each square represents one sub-band. Each rectangle represents N/2 subbands. The hierarchical filterbank performs the following steps:

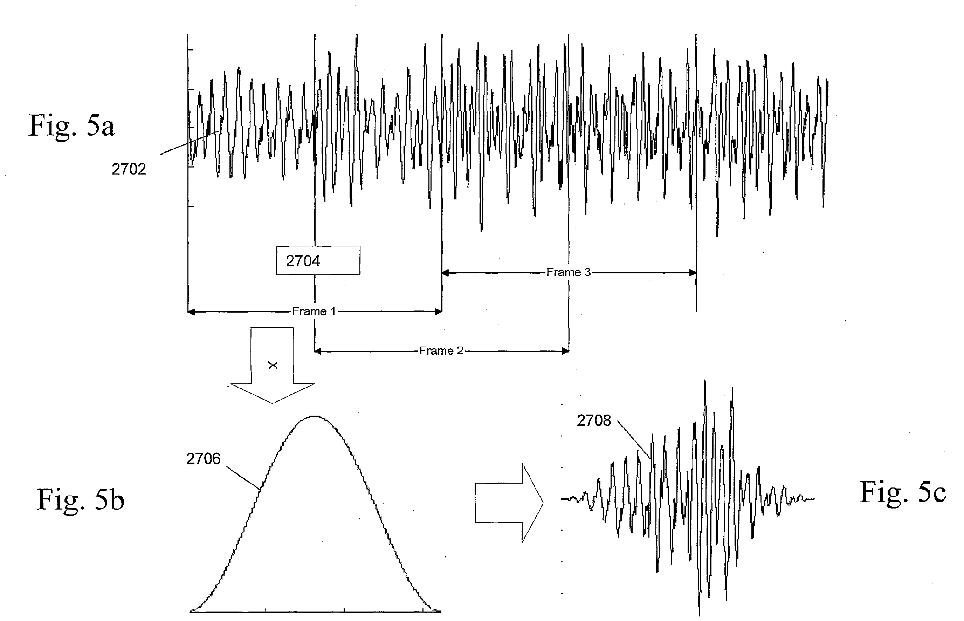

(a) As shown in Figure 5a, the input signal samples 2702 are buffered into Frames of N samples 2704, and each Frame is multiplied by an N-sample window function (Fig. 5b) 2706 to produce N windowed samples 2708 (Fig. 5c) (step 2900);

(b) As shown in Figure 3, an N-point Transform (represented by the downward arrow 2802 in Figure 3) is applied to the windowed samples 2708 to produce N/2 transform coefficients 2804 (step 2902);

(c) Optionally ringing reduction is applied to one or more of the transform coefficients 2804 by applying a linear combination of one or more adjacent transform coefficients (step 2904) ;

(d) The N/2 transform coefficients 2804 are divided into P groups of Mi coefficients, such that the sum of the $M_i$ coefficients is N/2 $\left( \displaystyle\sum_{i=1}^{P} M_i = N/2 \right)$;

(e) For each of P groups, a $(2*M_i)$-point inverse transform (represented by the upward arrow 2806 in Figure 3) is applied to the transform coefficients to produce $(2* M_i)$ sub-band samples from each group (step 2906);

(d) In each sub-band, the $(2* M_i)$ sub-band samples are multiplied by a $(2* M_i)$-point window function 2706 (step 2908);

(e) In each sub-band, the $M_i$ previous samples are overlapped and added to corresponding current values to produce $M_i$ new samples for each sub-band (step 2910);

(f) N is set equal to the previous Mi and select new values for P and Mi, and

(g) The above steps are repeated (step 2912) on one or more of the sub-bands of $M_i$ new samples using the successively smaller transform sizes for N until the desired time/transform resolution is achieved (step 2914). Note, steps may be iterated on all of the sub-bands, only the lowest sub-bands or any desired combination thereof. If the steps are iterated on all of the sub-bands the HFB is uniform, otherwise it is non-uniform.

The frequency response 3300 plot of an implementation of the filterbank of Figures 3 and described above is shown in Figure 6 in which N =128, Mi =16 and P= 4, and the steps are iterated on the lowest two sub-bands at each stage..

The potential applications for this hierarchical filterbank go beyond audio, to processing of video and other types of signals (e.g. seismic, medical, other time-series signals). Video coding and compression have similar requirements for time/frequency decomposition, and the arbitrary nature of the decomposition provided by the Hierarchical Filterbank may have significant advantages over current state-of-the-art techniques based on Discrete Cosine Transform and Wavelet decomposition. The filterbank may also be applied in analyzing and processing seismic or mechanical measurements, biomedical signal processing, analysis and processing of natural or physiological signals, speech, or other time-series signals. Frequency domain information can be extracted from the transform coefficients produced at each iteration at successively lower frequency resolutions. Likewise time domain information can be extracted from the time-domain sub-band samples produced at each iteration at successively finer time scales.

Hierarchical Filterbank: Uniformly Spaced Sub-Bands

Figure 7 shows a block diagram of an exemplary embodiment of the Hierarchical Filterbank 3900, which implements a uniformly spaced sub-band filterbank. For a uniform filterbank $M_i$ =M =N/(2*P). The decomposition of the input signal into sub-band signals 3914 is described as follows:

1. Input time samples 3902 are windowed in N-point, 50% overlapping frames 3904.

2. A N-point MDCT 3906 is performed on each frame.

3. The resulting MDCT coefficients are grouped in P groups 3908 of M coefficients in each group.

4. A (2*M)-point IMDCT 3910 is performed on each group to form (2*M) sub-band time samples 3911.

5. The resulting time samples 3911 are windowed in (2*M)-point, 50% overlapping frames and overlap-added (OLA) 3912 to form M time samples in each sub-band 3914.

In an exemplary implementation, N=256, P=32, and M=4. Note that different transform sizes and sub-band groupings represented by different choices for N, P, and M can also be employed to achieve a desired time/frequency decomposition.

Hierarchical Filterbank: Non-Uniformly Spaced Sub-Bands

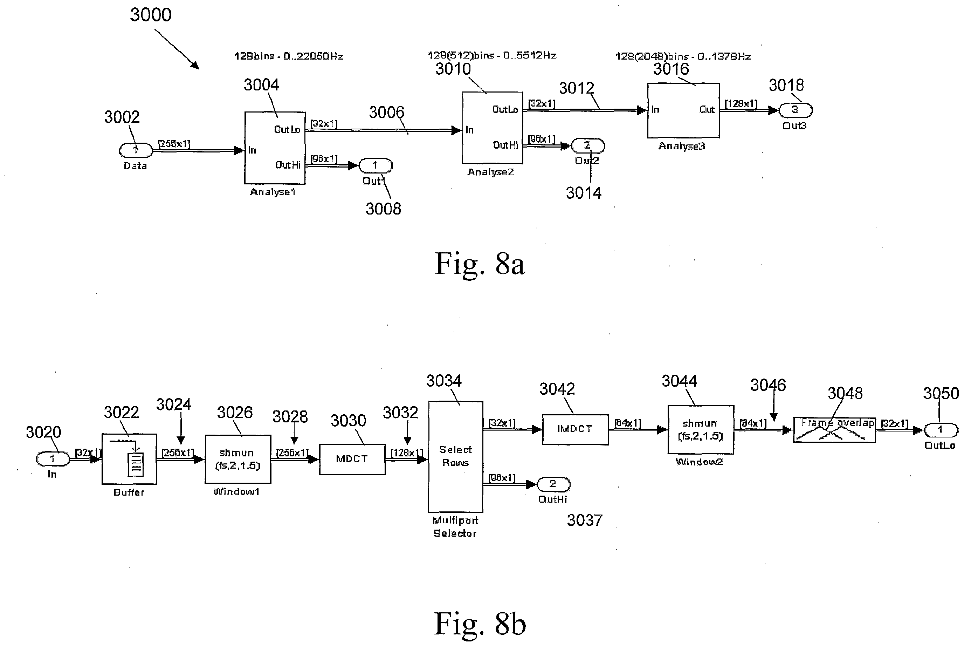

Another embodiment of a Hierarchical Filterbank 3000 is shown in Figures 8a and 8b. In this embodiment, some of the filterbank stages are incomplete to produce a transform with three different frequency ranges with the transform coefficients representing a different frequency resolution in each range. The time domain signal is decomposed into these transform coefficients using a series of cascaded single-element filterbanks. The detailed filterbank element may be iterated a number of times to produce a desired time/frequency decomposition. Note that the numbers for buffer sizes, transform sizes and window sizes, and the use of the MDCT/IMDCT for the transform are for one exemplary embodiment only and do not limit the scope of the present invention. Other buffer window and transform sizes and other transform types may also be used. In general, the $M_i$ differ from each other but satisfy the constraint that the sum of the $M_i$ equals N/2.

As shown in Figure 8b, a single filterbank element buffers 3022 input samples 3020 to form buffers of 256 samples 3024, which are windowed 3026 by multiplying the samples by a 256-sample window function. The windowed samples 3028 are transformed via a 256-point MDCT 3030 to form 128 transform coefficients 3032. Of these 128 coefficients, the 96 highest frequency coefficients are selected 3034 for output 3037 and are not further processed. The 32 lowest frequency coefficients are then inverse transformed 3042 to produce 64 time domain samples, which are then windowed 3044 into samples 3046 and overlap-added 3048 with the previous output frame to produce 32 output samples 3050.

In the example shown in Figure 8a, the filterbank is composed of one filterbank element 3004 iterated once with an input buffer size of 256 samples followed by one filterbank element 3010 also iterated with an input buffer size of 256 samples. The last stage 3016 represents an abbreviated single filterbank element and is composed of the buffering 3022, windowing 3026, and MDCT 3030 steps only to output 128 frequency domain coefficients representing the lowest frequency range of 0-1378 Hz.

Thus, assuming an input 3002 with a sample rate of 44100 Hz, the filterbank shown produces 96 coefficients representing the frequency range 5513 to 22050 Hz at "Out1" 3008, 96 coefficients representing the frequency range 1379 to 5512 Hz at "Out2" 3014, and 128 coefficients representing the frequency range 0 to 1378 Hz at "Out3" 3018,

It should be noted that the use of MDCT/IMDCT for the frequency transform/inverse transform are exemplary and other time/frequency transformations can be applied as part of the present invention. Other values for the transform sizes are possible, and other decompositions are possible with this approach, by selectively expanding any branch in the hierarchy described above.

Multichannel Joint Coding of Tonal and Residual Components

The Tone Selector 103 in Figure 1 takes as input, data from the Mask Calculator 101 and the tone list from Multi-Order Tone Extractor 102. The Tone Selector 103 first sorts the tone list by relative power over the masking level from Mask Calculator 101, forming an ordering by psychoacoustic importance. The formula employed is given by:

$$P_k = A_k \cdot \frac{\sum_{i=0}^{l-1}\left(1-\cos\left(\frac{\pi\,(2i+1)}{l}\right)\right)}{\sqrt{M_{i,k}}}$$

where:

$A_k$ = spectral line amplitude

$M_{i,k}$ = masking level for k's spectral line in i's mask sub - frame

$l$ = length of base function in terms of mask sub - frames

The summation is performed over the sub-frames where the spectral component has non-zero value.

Tone Selector 103 then uses an iterative process to determine which tonal components from the sorted tone list for the frame will fit into the bit stream. In stereo or multichannel audio signals, where the amplitude of a tone is about the same in more than one channel, only the full amplitude and phase is stored in the primary channel; the primary channel being the channel with the highest amplitude for the tonal component. Other channels having similar tonal characteristics store the difference from the primary channel.

The data for each transform size encompasses a number of sub-frames, the smallest transform size covering 2 sub-frames; the second 4 sub-frames; the third 8 sub-frames; the fourth 16 sub-frames; and the fifth 32 sub-frames. There are 16 sub-frames to 1 frame. Tone data is grouped by size of the transform in which the tone information was found. For each transform size, the following tonal component data is quantized, entropy-encoded and placed into the bit stream: entropy-coded sub-frame position, entropy-coded spectral position, entropy-coded quantized amplitude, and quantized phase.

In the case of multichannel audio, for each tonal component, one channel is selected as the primary channel. The determination of which channel should be the primary channel may be fixed or may be made based on the signal characteristics or perceptual criteria. The channel number of the primary channel and its amplitude and phase are stored in the bit stream. As shown in Figure 9, a bit-mask 3602 is stored which indicates which of the other channels include the indicated tonal component, and should therefore be coded as secondary channels. The difference between the primary and secondary amplitudes and phases are then entropy-coded and stored for each secondary channel in which the tonal component is present. This particular example assumes there are 7 channels, and the main channel is channel 3. The bit-mask 3602 indicates the presence of the tonal component on the secondary channels 1, 4, and 5. There is no bit used for the primary channel.

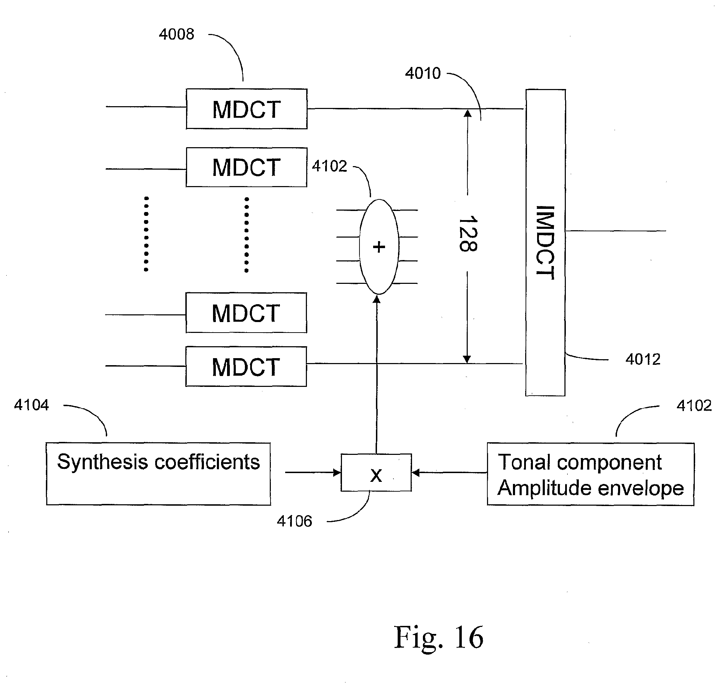

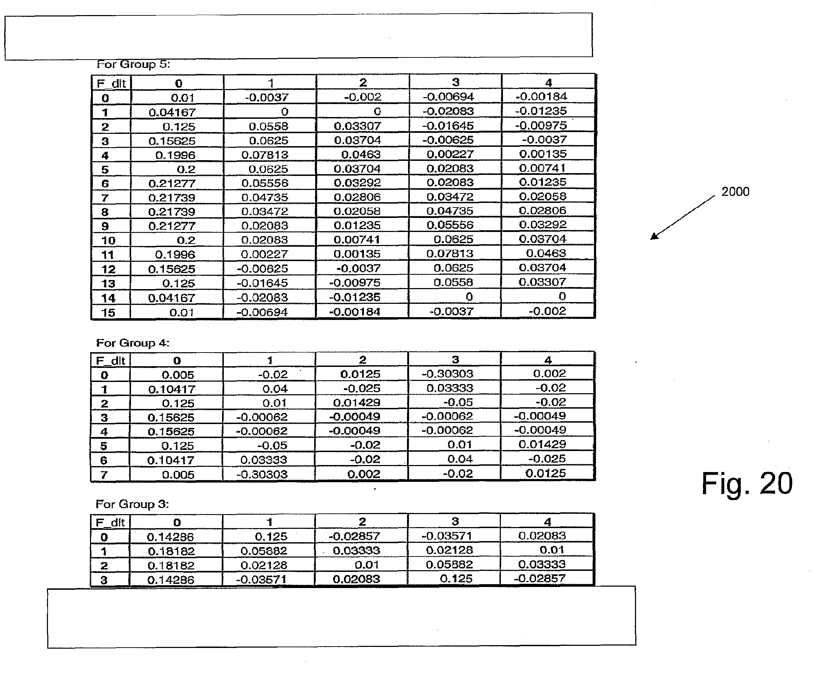

The output 4211 of Multi-Order Tone Extractor 102 is made up of frames of MDCT coefficients at one or more resolutions. The Tone Selector 103 determines which tonal components can be retained for insertion into the bit stream output frame by Code String Generator 108, based on their relevance to decoded signal quality. Those tonal components determined not to fit in the frame are output 110 to the Local Decoder 104. The Local Decoder 104 takes the output 110 of the Tone Selector 103 and synthesizes all tonal components by adding each tonal component scaled with synthesis coefficients 2000 from a lookup table (Figure 20) to produce frames of MDCT coefficients (See Figure 16). These coefficients are added to the output 111 of Multi-Order Tone Extractor 102 in the Combiner 105 to produce a residual signal 113 in the MDCT resolution of the last iteration of the hierarchical filterbank.

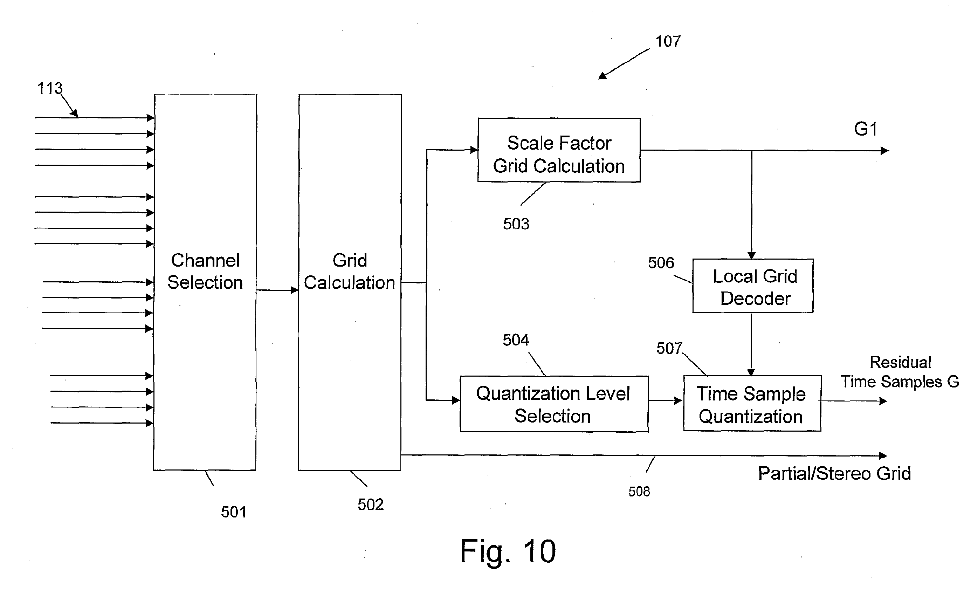

As shown in Figure 10, the residual signal 113 for each channel is passed to the Residual Encoder 107 as the MDCT coefficients 3908 of the hierarchical filterbank 3900, prior to the steps of windowing and overlap add 3904 and IMDCT 3910 shown in Figure 7. The subsequent steps of IMDCT 3910, windowing and overlap-add 3912 are performed to produce 32 equally-spaced critically sampled frequency sub-bands 3914 in the time domain for each channel. The 32 subbands, which make-up the time-sample components, are referred to as grid G. Note that other embodiments of the hierarchical filterbank could be used in an encoder to implement different time/frequency decompositions than the one outlined above and other transforms could be used to extract tonal components. If a hierarchical filterbank is not used to extract tonal components, another form of filterbank can be used to extract the subbands but at a higher computational burden.

For stereo or multichannel audio, several calculations are made in Channel Selection block 501 to determine the primary and secondary channel for encoding tonal components, as well as the method for encoding tonal components (for example, Left-Right, or Middle-Side). As shown in Figure 11, a channel grouping process 3702 first determines which of the multiple channels may be jointly coded and all channels are formed into groups with the last group possibly being incomplete. The groupings are determined by perceptual criteria of a listener and coding efficiency, and channel groups may be constructed of combinations of more than two channels (for example, a 5-channel signal composed of L, R, Ls, Rs and C channels may be grouped as {L,R}, {Ls, Rs}, {L+R, C}. The channel groups are then ordered as Primary and Secondary channels. In an exemplary multichannel embodiment, the selection of the primary channel is made based on the relative power of the channels over the frame. The following equations define the relative powers:

$$P_l = \sum_{i=0}^{15} L_i^2 \qquad P_r = \sum_{i=0}^{15} R_i^2 \qquad P_m = \sum_{i=0}^{15} (L_i + R_i)^2 \qquad P_s = \sum_{i=0}^{15} (L_i - R_i)^2$$

The grouping mode is also determined as shown in step 3704 of Figure 11. The tonal components may be encoded as Left-Right or Middle-Side representation, or the output of this step may result in a single primary channel only as shown by the dotted lines. In Left-Right representation, the channel with the highest power for the sub-band is considered the primary and a single bit in the bit stream 3706 for the sub-band is set if the right channel is the channel of highest power. Middle-Side encoding is used for a sub-band if the following condition is met for the sub-band:

$$P_m > 2 \cdot P_s$$

For multichannel signals, the above is performed for each channel group.

For a stereo signal, Grid Calculation 502 provides a stereo panning grid in which stereo panning can roughly be reconstructed and applied to the residual signal. The stereo grid is 4 sub-bands by 4 time intervals, each sub-band in the stereo grid covers 4 sub-bands and 32 samples from the output of Filter Bank 500, starting with frequency bands above 3k Hz. Other grid sizes, frequency sub-bands covered, and time divisions could be chosen. Values in the cells of the stereo grid are the ratio of the power of the given channel to that of the primary channel, for the range of values covered by the cell. The ratio is then quantized to the same table as that used to encode tonal components. For multichannel signals, the above stereo grid is calculated for each channel group.

For multichannel signals, Grid Calculation 502 provides multiple scale factor grids, one per each channel group, that are inserted into the bit stream in order of their psychoacoustic importance in the spatial domain. The ratio of the power of the given channel to the primary channel for each group of 4 sub-bands by 32 samples is calculated. This ratio is then quantized and this quantized value plus logarithm sign of the power ratio is inserted into the bit stream.

Scale Factor Grid Calculation 503 calculates grid G1, which is placed in the bit stream. The method for calculating G1 is now described. G0 is first derived from G. G0 contains all 32 sub-bands but only half the time resolution of G. The contents of the cells in G0 are quantized values of the maximum of two neighboring values of a given sub-band from G. Quantization (referred to in the following equations as *Quantize*) is performed using the same modified logarithmic quantization table as was used to encode the tonal components in the Multi-Order Tone Extractor 102. Each cell in G0 is thus determined by:

$$G0_{m,n} = Quantize\left(Maximum\left(G_{m,2n}, G_{m,2n+1}\right)\right) \qquad n \in \left[0\ldots 63\right]$$

where:

　　　*m* is the sub-band number
　　　*n* is the G0's column number

[0057]　G1 is derived from G0. G1 has 11 overlapping sub-bands and 1/8 the time resolution of G0, forming a grid 11 x 8 in dimension. Each cell in G1 is quantized using the same table as used for tonal components and found using the

$$G1_{m,n} = Quantize\left(\sum_{l=0}^{31}\left(W_l \cdot \sqrt{\sum_{i=8n}^{8n+7} G_{l,i}^2}\right)\right)$$

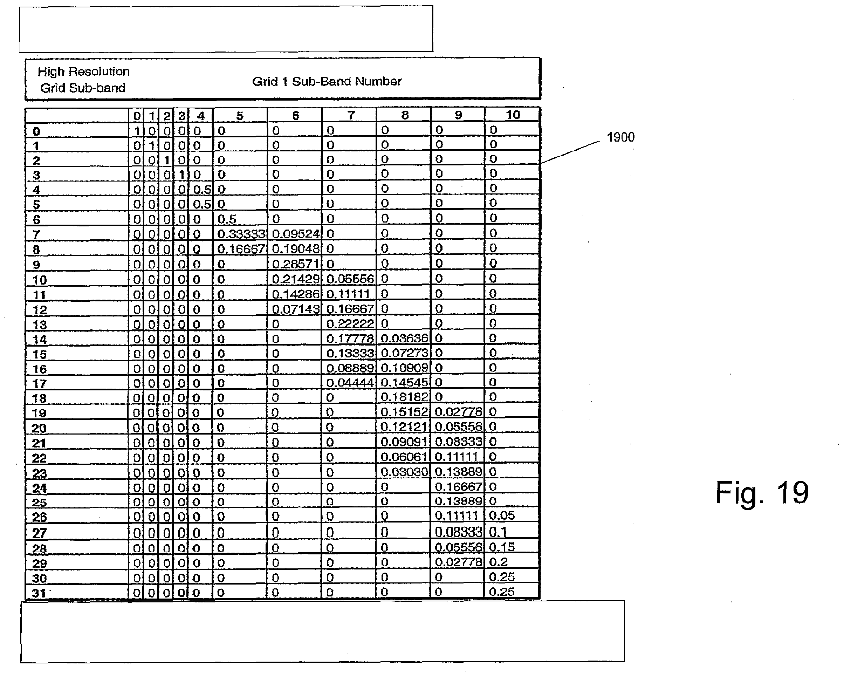

following formula:　　　　　　　　　　　　　　　　　　　　　　where: $W_l$ is a weight value obtained from the Table 1 in Figure 19.

G0 is recalculated from G1 in Local Grid Decoder 506. In Time Sample Quantization Block 507, output time samples ("time-sample components') are extracted from the hierarchical filterbank (Grid G), which pass through Quantization Level Selection Block 504, scaled by dividing the time-sample components by the respective values in the recalculated G0 from Local Grid Decoder 506 and quantized to the number of quantization levels, as a function of sub-band, determined by quantization level selection block 504. These quantized time samples are then placed into the encoded bit stream along with the quantized grid G1. In all cases, a model reflecting the psychoacoustic importance of these components is used to determine priority for the bit stream storage operation.

In an additional enhancement step to improve the coding gain for some signals, grids including G, G1 and partial grids may be further processed by applying a two-dimensional Discrete Cosine Transform (DCT) prior to quantization and coding. The corresponding Inverse DCT is applied at the decoder following inverse quantization to reconstruct the original grids.

**Scalable Bit Stream and Scaling Mechanism**

Typically, each frame of the master bit stream will include (a) a plurality of quantized tonal components representing frequency domain content at different frequency resolutions of the input signal, b) quantized residual time-sample components representing the time-domain residual formed from the difference between the reconstructed tonal components and the input signal, and c) scale factor grids representing the signal energies of the residual signal, which span a frequency range of the input signal. For a multichannel signal each frame may also contain d) partial grids representing the signal energy ratios of the residual signal channels within channel groups and e) a bitmask for each primary specifying the joint-encoding of secondary channels for tonal components. Usually a portion of the available data rate in each frame is allocated from the tonal components (a) and a portion is allocated for the residual components (b,c). However, in some cases all of the available rate may be allocated to encode the tonal components. Alternately, all of the available rate may be allocated to encode the residual components. In extreme cases, only the scale factor grids may be encoded, in which case the decoder uses a noise signal to reconstruct an output signal. In most any actual application, the scaled bit stream will include at least some frames that contain tonal components and some frames that include scale factor grids.

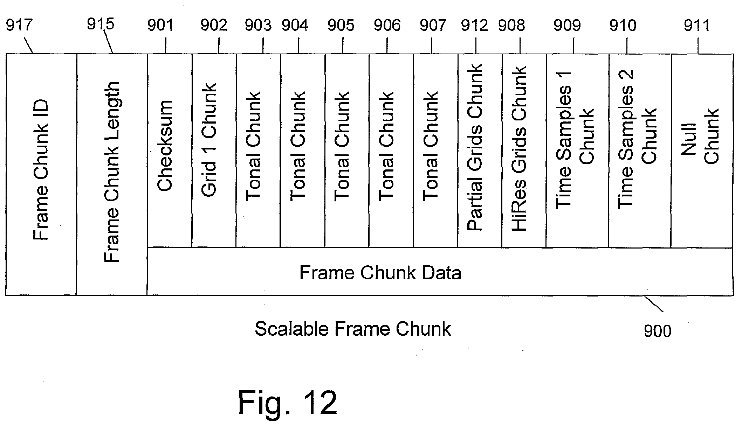

The structure and order of components placed in the master bit stream, as defined by the present invention, provides for wide bit range, fined grained, bit stream scalability. It is this structure and order that allows the bit stream to be smoothly scaled by external mechanisms. Figure 12 depicts the structure and order of components based on the audio compression codec of Figure 1 that decomposes the original bit stream into a particular set of psychoacoustically relevant components. The scalable bit stream used in this example is made up of a number of Resource Interchange File Format, or RIFF, data structures called "chunks", although other data structures can be used. This file format which is well known by those skilled in the art, allows for identification of the type of data carried by a chunk as well as the amount of data carried by a chunk. Note that any bit stream format that carries information regarding the amount and type of data carried in its defined bit stream data structures can be used to practice the present invention.

Figure 12 shows the layout of a scalable data rate frame chunk 900, along with sub-chunks 902, 903, 904, 905, 906, 906, 907, 908, 909, 910 and 912, which comprise the psychoacoustic data being carried within frame chunk 900. Although Figure 12 only depicts chunk ID and chunk length for the frame chunk, sub-chunk ID and sub-chunk length data is included within each sub-chunk. Figure 12 shows the order of sub-chunks in a frame of the scalable bit stream. These sub-chunks contain the psychoacoustic components produced by the scalable bit stream encoder, with a unique sub-chunk used for each sub-domain of the encoded bit stream. In addition to the sub-chunks being arranged in psychoacoustic importance, either by a priori decision or calculation, the components within the sub-chunks are also arranged in psychoacoustic importance. Null Chunk 911, which is the last chunk in the frame, is used to pad chunks in the case where the frame is required to be a constant or specific size. Therefore Chunk 911 has no psychoacoustic relevance and is the least important psychoacoustic chunk. Time Samples 2 Chunk 910 appears on the right hand side of the figure and the most important psychoacoustic chunk, Grid 1 Chunk 902 appears on the left hand side of the figure. By operating to first remove data from the least psychoacoustically relevant chunk at the end of the bit stream, Chunk 910 and working towards removing greater and greater psychoacoustically relevant components toward the beginning of the bit stream, Chunk 902, the highest quality possible is maintained for each successive reduction in data rate. It should be noted that the highest data rate, along with the highest audio quality, able to be supported by the bit stream, is defined at encode time. However, the lowest data rate after scaling is defined by the level of audio quality that is acceptable for use by an application or by the rate constraint placed on the channel or media.

Each psychoacoustic component removed does not utilize the same number of bits. The scaling resolution for the current implementation of the present invention ranges from 1 bit for components of lowest psychoacoustic importance to 32 bits for those components of highest psychoacoustic importance. The mechanism for scaling the bit stream does not need to remove entire chunks at a time. As previously mentioned, components within each chunk are arranged so that the most psychoacoustically important data is placed at the beginning of the chunk. For this reason, components can be removed from the end of the chunk, one component at a time, by a scaling mechanism while maintaining the best audio quality possible with each removed component. In one embodiment of the present invention, entire components are eliminated by the scaling mechanism, while in other embodiments, some or all of the components may be eliminated. The scaling mechanism removes components within a chunk as required, updating the Chunk Length field of the particular chunk from which the components were removed, the Frame Chunk Length 915 and the Frame Checksum 901. As will be seen from the detailed discussion of the exemplary embodiments of the present invention, with updated Chunk Length for each chuck scaled, as well as updated Frame Chunk Length and Frame Checksum information available to the decoder, the decoder can properly process the scaled bit stream, and automatically produce a fixed sample rate audio output signal for delivery to the DAC, even though there are chunks within the bit stream that are missing components, as well as chunks that are completely missing from the bit stream.

**Scalable Bit Stream Decoder for a Residual Coding Topology**

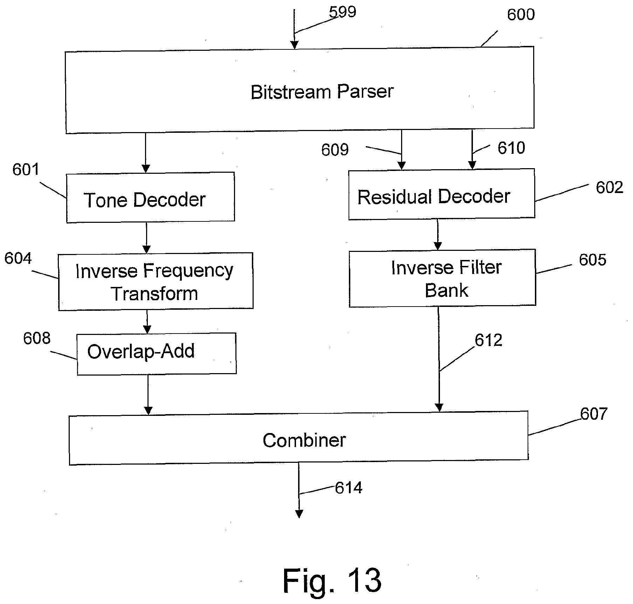

Figure 13 shows the block diagram for the decoder. The Bit stream Parser 600 reads initial side information consisting of: the sample rate in Hertz of the encoded signal before encoding, the number of channels of audio, the original data rate of the stream, and the encoded data rate. This initial side information allows it to reconstruct the full data rate of the original signal. Further components in bit stream 599 are parsed by the Bit stream Parser 600 and passed to the appropriate decoding element: Tone Decoder 601 or Residual Decoder 602. Components decoded via the Tone Decoder 601 are processed through the Inverse Frequency Transform 604 which converts the signal back into the time domain. The Overlap-Add block 608 adds the values of the last half of the previously decoded frame to the values of the first half of the just decoded frame which is the output of Inverse Frequency Transform 604. Components which the Bit stream Parser 600 determines to be part of the residual decoding process are processed though the Residual Decoder 602. The output of the Residual Decoder 602, containing 32 frequency sub-bands represented in the time domain, is processed through the Inverse Filter Bank 605. Inverse Filter Bank 605 recombines the 32 sub-bands into one signal to be combined with the output of the Overlap-Add 608 in Combiner 607. The output of Combiner 607 is the decoded output signal 614.

To reduce computational burden, the Inverse Frequency Transform 604 and Inverse Filter Bank 605 which convert the signals back into the time domain can be implemented with an inverse Hierarchical Filterbank, which integrates these operations with the Combiner 607 to form decoded time domain output audio signal 614. The use of the hierarchical filterbank in the decoder is novel in the way in which the tonal components are combined with the residual in the hierarchical filterbank at the decoder. The residual signals are forward transformed using MDCTs in each sub-band, and then the tonal components are reconstructed and combined prior to the last stage IMDCT. The multi-resolution approach could be generalized for other applications (e.g. multiple levels, different decompositions would still be covered by this aspect of the invention).

Inverse Hierarchical Filterbank

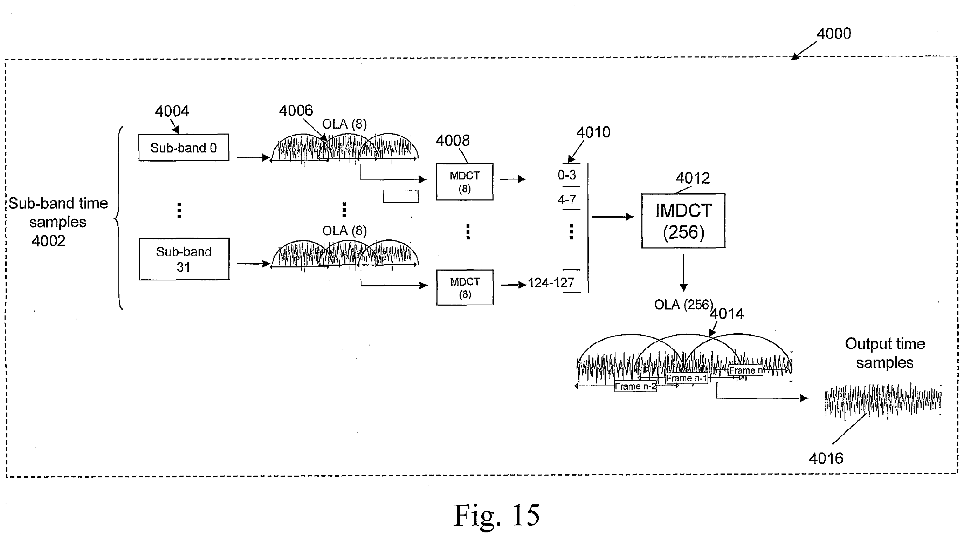

In order to reduce complexity of the decoder, the hierarchical filterbank may be used to combine the steps of Inverse Frequency Transform 604, Inverse Filterbank 605, Overlap-Add 608, and Combiner 607. As shown in Figure 15, the output of the Residual Decoder 602 is passed to the first stage of the Inverse Hierarchical Filterbank 4000 while the output of the Tone Decoder 601 is added to the Residual samples in the higher frequency resolution stage prior to the final inverse transform 4010. The resulting inverse transformed samples are then overlap added to produce the linear output samples 4016.

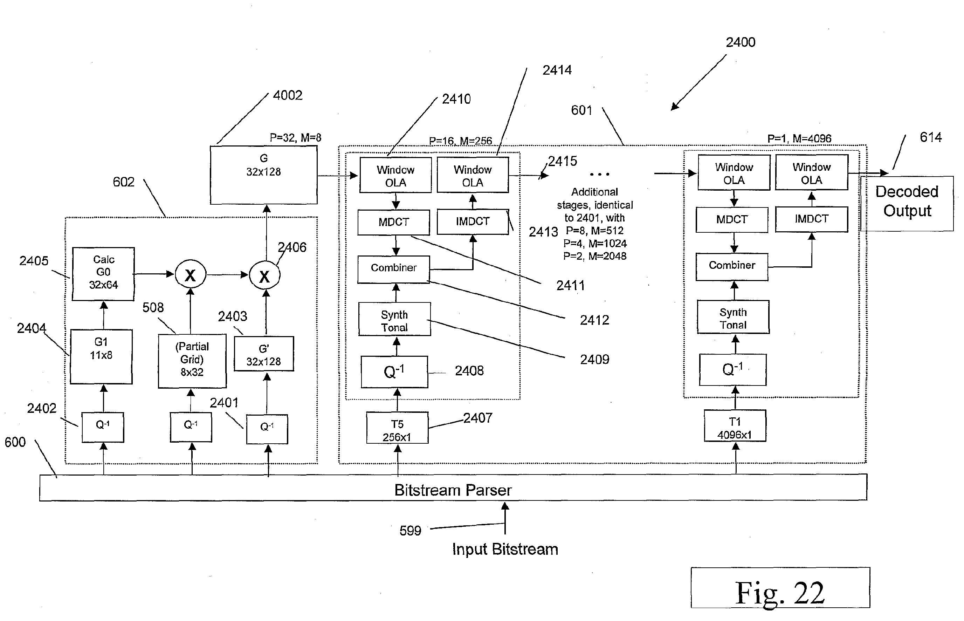

The overall operation of the decoder for a single channel using the HFB 2400 is shown in Figure 22. The additional steps for multichannel decoding of the tones and residual signals are shown in Figures 10, 11 and 18. Quantized Grids G1 and G' are read from the bit stream 599 by Bit stream Parser 600. Residual decoder 602 inverse quantizes ($Q^{-1}$) 2401, 2402 Grids G' 2403 and G1 2404 and reconstructs Grid G0 2405 from Grid G1. Grid G0 is applied to Grid G' by multiplying 2406 corresponding elements in each grid to form the scaled Grid G, which consists of sub-band time samples 4002 which are input to the next stage in the hierarchical filterbank 2401. For a multichannel signal, partial grid 508 would be used to decode the secondary channels.

The tonal components (T5) 2407 at the lowest frequency resolution (P=16, M=256) are read from the bit stream by Bit stream Parser 600. Tone decoder 601 inverse quantizes 2408 and synthesizes 2409 the tonal component to produce P groups of M frequency domain coefficients.

The Grid G time samples 4002 are windowed and overlap-added 2410 as shown in Figure 15, then forward transformed by P (2*M)-point MDCTs 2411 to form P groups of M frequency domain coefficients which are then combined 2412 with the P groups of M frequency domain coefficients synthesized from the tonal components as shown in Figure 16. The combined frequency domain coefficients are then concatenated and inverse transformed by a length-N IMDCT 2413, windowed and overlap-added 2414 to produce N output samples 2415 which are input to the next stage of the hierarchical filterbank.

The next lowest frequency resolution tonal components (T4) are read from the bit stream, and combined with the output of the previous stage of the hierarchical filterbank as described above, and then this iteration continues for P=8, 4, 2, 1 and M=512, 1024, 2048, and 4096 until all frequency components have been read from the bit stream, combined and reconstructed.

At the final stage of the decoder, the inverse transform produces N full-bandwidth time samples which are output as Decoded Output 614. The preceding values of P, M and N are for one exemplary embodiment only and do not limit the scope of the present invention. Other buffer, window and transform sizes and other transform types may also be used.

As described, the decoder anticipates receiving a frame that includes tonal components, time-sample components and scale factor grids. However, if one or more of these are missing from the scaled bit stream the decoder seamlessly reconstructs the decoded output. For example, if the frame includes only tonal components then the time-samples at 4002 are zero and no residual is combined 2403 with the synthesized tonal components in the first stage of the inverse HFB. If one or more of the tonal components T5, ... T1 are missing, than a zero value is combined 2403 at that iteration. If the frame includes only the scale-factor grids, then the decoder substitutes a noise signal for Grid G to decode the output signal. As a result, the decoder can seamlessly reconstruct the decoded output signal as the composition of each frame of the scaled bit stream may change due to the content of the signal, changing data rate constraints, etc.

Figure 16 shows in more detail how tonal components are combined within the Inverse Hierarchical Filterbank of Figure 15. In this case, the sub-band residual signals 4004 are windowed and overlap-added 4006, forward transformed 4008 and the resulting coefficients from all sub-bands are grouped to form single frame 4010 of coefficients. Each tonal coefficient is then combined with the frame of residual coefficients by multiplying 4106 the tonal component amplitude envelope 4102 by a group of synthesis coefficients 4104 (normally provided by table lookup) and adding the results to the coefficients centered around the given tonal component frequency 4106. The addition of these tonal synthesis coefficients is performed on the spectral lines of the same frequency region over the full length of tonal component. After all tonal components are added in this way, the final IMDCT 4012 is performed and the results are windowed and overlap-added 4014 with the previous frame to produce the output time samples 4016.

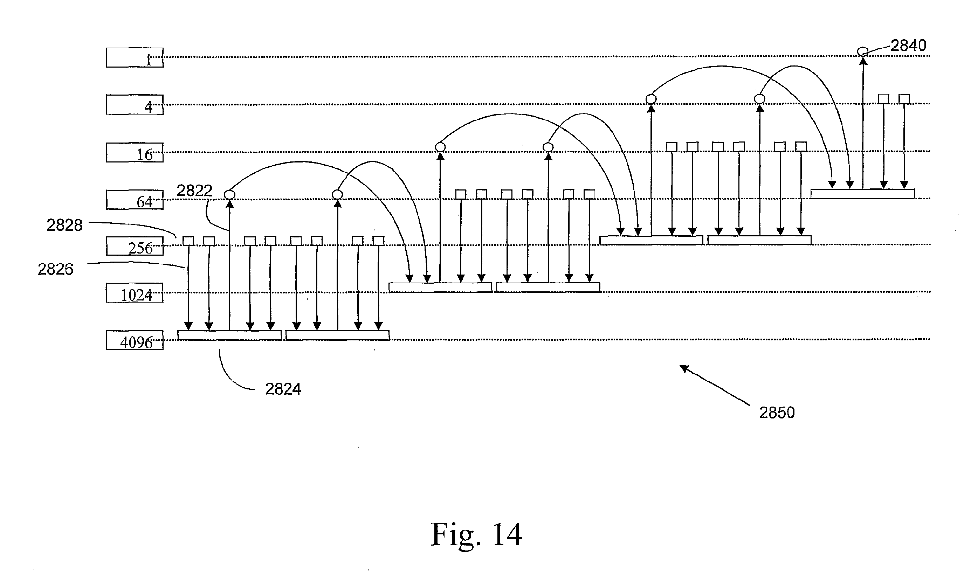

The general form of the Inverse Hierarchical Filterbank 2850 is shown in Figure 14 which is compatible with the Hierarchical Filterbank shown in Figure 3. Each input frame contains $M_i$ time samples in each of P sub-bands, such that the sum of the $M_i$ coefficients is N/2:

$$\sum_{i=1}^{P} M_i = N/2 \,;$$

In Figure 14, upward arrows represent an N-point IMDCT transform which takes N/2 MDCT coefficients and transforms them into N time-domain samples. Downward arrows represent an MDCT which takes N/4 samples within one sub-band and transforms them into N/8 MDCT coefficients. Each square represents one subband. Each rectangle represents N/2 MDCT coefficients. The following steps are shown in Figure 14:

(a) In each sub-band, the $M_i$ previous samples are buffered and concatenated with the current $M_i$ samples to produce (2*$M_i$) new samples for each sub-band 2828;

(b) In each sub-band, the (2*$M_i$) sub-band samples are multiplied by a (2*$M_i$)-point window function 2706 (Fig. 5a-5c);

(c) A (2*$M_i$)-point transform (represented by the downward arrow 2826) is applied to produce $M_i$ transform coefficients for each subband;

(d) The $M_i$ transform coefficients for each subband are concatenated to form a single group 2824 of N/2 coefficients;

(e) An N-point Inverse Transform (represented by the upward arrow 2822) is applied to the concatenated coefficients to produce N samples;

(f) Each Frame of N samples 2704 is multiplied by an N-sample window function 2706 to produce N windowed samples 2708;

(g) The resulting windowed samples 2708 are overlap added to produce N/2 new output samples at the given sub-band level;

(h) The above steps are repeated at the current level and all subsequent levels until all sub-bands have been processed and the original time samples 2840 are reconstructed.

Inverse Hierarchical Filterbank: Uniformly Spaced Sub-Bands

Figure 15 shows a block diagram of an exemplary embodiment of an Inverse Hierarchical Filterbank 4000 compatible with the forward filterbank shown in Figure 7. The synthesis of the decoded output signal 4016 is described in more detail as follows:

1. Each input frame 4002 contains M time samples in each of P sub-bands.

2. Buffer each sub-band 4004, shift in M new samples, apply (2*M)-point window, 50% overlap-add (OLA) 4006 to produce M new sub-band samples.

3. A (2*M)-point MDCT 4008 performed within each sub-band to form M MDCT coefficients in each of P sub-bands.

4. The resulting MDCT coefficients are grouped to form single frame 4010 of (N/2) MDCT coefficients.

5. An N-point IMDCT 4012 performed on each frame

6. The IMDCT output is windowed in N-point, 50% overlapping frames and overlap-added 4014 to form N/2 new output samples 4016.

In an exemplary implementation, N=256, P=32, and M=4. Note that different transform sizes and sub-band groupings represented by different choices for N, P, and M can also be employed to achieve a desired time/frequency decomposition.

Inverse Hierarchical Filterbank: Non-Uniformly Spaced Sub-Bands

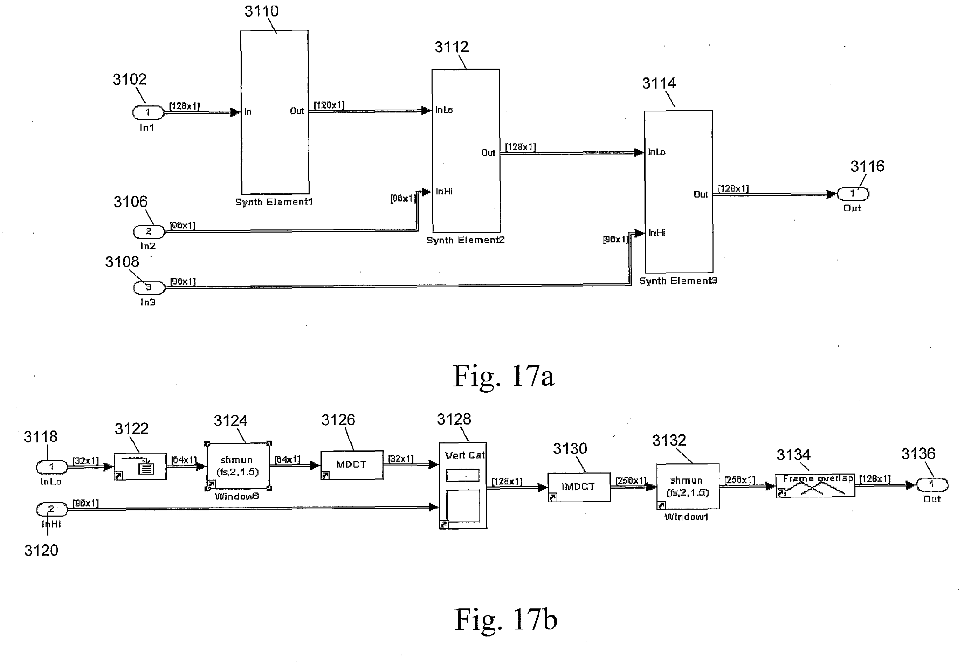

Another embodiment of the Inverse Hierarchical Filterbank is shown in Figure 17a-b, which is compatible with the filterbank show in Fig. 8a-b. In this embodiment, some of the detailed filterbank elements are incomplete to produce a transform with three different frequency ranges with the transform coefficients representing a different frequency resolution in each range. The reconstruction of the time domain signal from these transform coefficients is described as follows:

In this case, the first synthesis element 3110 omits the steps of buffering 3122, windowing 3124, and the MDCT 3126 of the detailed element shown in Figure 17b. Instead, the input 3102 forms a single set of coefficients which are inverse transformed 3130 to produce 256 time samples, which are windowed 3132 and overlap-added 3134 with the previous frame to produce the output 3136 of 128 new time samples for this stage.

The output of the first element 3110 and 96 coefficients 3106 are input to the second element 3112 and combined as shown in Figure 17b to produce 128 time samples for input to the third element 3114 of the filterbank. The second element 3112 and third element 3114 in Figure 17a implement the full detailed element of Figure 17b, cascaded to produce 128 new time samples output from the filterbank 3116. Note that the buffer and transform sizes are provided as examples only, and other sizes may be used. In particular note that the buffering 3122 at the input to the detailed element may change to accommodate different input sizes depending on where it is used in the hierarchy of the general filterbank.

Further details regarding the decoder blocks will now be described.

Bit stream Parser 600

The Bit stream Parser 600 reads IFF chunk information from the bit stream and passes elements of that information on to the appropriate decoder, Tone Decoder 601 or Residual Decoder 602. It is possible that the bit stream may have been scaled before reaching the decoder. Depending on the method of scaling employed, psychoacoustic data elements at the end of a chunk may be invalid due to missing bits. Tone Decoder 601 and Residual Decoder 602 appropriately ignore data found to be invalid at the end of a chunk. An alternative to Tone Decoder 601 and Residual Decoder 602 ignoring whole psychoacoustic data elements, when bits of the element are missing, is to have these decoders recover as much of the element as possible by reading in the bits that do exist and filling in the remaining missing bits with zeros, random patterns or patterns based on preceding psychoacoustic data elements. Although more computationally intensive, the use of data based on preceding psychoacoustic data elements is preferred because the resulting decoded audio can more closely match the original audio signal.

Tone Decoder 601

Tone information found by the Bit stream Parser 600 is processed via Tone Decoder 601. Re-synthesis of tonal components is performed using the hierarchical filterbank as previously described. Alternatively, an Inverse Fast Fourier Transform whose size is the same size as the smallest transform size which was used to extract the tonal components at the encoder can be used.

The following steps are performed for tonal decoding:

    a) Initialize the frequency domain sub-frame with zero values
    b) Re-synthesize the required portion of tonal components from the smallest transform size into the frequency domain sub-frame
    c) Re-synthesize and add at the required positions, tonal components from the other four transform sizes into the same sub-frame. The re-synthesis of these other four transform sizes can occur in any order.

Tone Decoder 601 decodes the following values for each transform size grouping: quantized amplitude, quantized phase, spectral distance from the previous tonal component for the grouping, and the position of the component within the full frame. For multichannel signals, the secondary information is stored as differences from the primary channel values and needs to be restored to absolute values by adding the values obtained from the bit stream to the value obtained for the primary channel. For multichannel signals, per-channel 'presence' of the tonal component is also provided by the bit mask 3602 which is decoded from the bit stream. Further processing on secondary channels is done independently of the primary channel. If Tone Decoder 601 is not able to fully acquire the elements necessary to reconstruct a tone from the chunk, that tonal element is discarded. The quantized amplitude is dequantized using the inverse of the table used to quantize the value in the encoder. The quantized phase is dequantized using the inverse of the linear quantization used to quantize the phase in the encoder. The absolute frequency spectral position is determined by adding the difference value obtained from the bit stream to the previously decoded value. Defining *Amplitude* to be the dequantized amplitude, *Phase* to be the dequantized phase, and *Freq* to be the absolute frequency position, the following pseudo-code describes the re-synthesis of tonal components of the smallest transform size:

$$\text{Re[Freq]} \qquad += \qquad \text{Amplitude} * \sin( 2 * \text{Pi} * \text{Phase} / 8 );$$

$$\text{Im[Freq]} \qquad += \qquad \text{Amplitude} * \cos( 2 * \text{Pi} * \text{Phase} / 8 );$$

$$\text{Re[Freq} + 1] \qquad += \qquad \text{Amplitude} * \sin( 2 * \text{Pi} * \text{Phase} / 8 );$$

$$\text{Im[Freq} + 1] \qquad += \qquad \text{Amplitude} * \cos( 2 * \text{Pi} * \text{Phase} / 8);$$

Re-synthesis of longer base functions are spread over more sub-frames therefore the amplitude and phase values need to be updated according to the frequency and length of the base function. The following pseudo-code describes how this is done:

```
xFreq = Freq >> (Group – 1);
CurrentPhase = Phase – 2 * (2 * xFreq + 1);
for (i = 0; i < length; i = i + 1)
{
        CurrentPhase += 2 * (2 * Freq + 1) / length;
        CurrentAmplitude = Amplitude * Envelope[Group][i];

        Re[i][xFreq] += CurrentAmplitude * sin( 2 * Pi * CurrentPhase / 8 );
        Im[i][xFreq] += CurrentAmplitude * cos( 2 * Pi * CurrentPhase / 8 );
        Re[i][xFreq+1] += CurrentAmplitude * sin( 2 * Pi * CurrentPhase / 8 );
        Im[i][xFreq+1] += CurrentAmplitude * cos( 2 * Pi * CurrentPhase / 8 );
}
```

where:

*Amplitude, Freq* and *Phase* are the same as previously defined.
*Group* is a number representing the base function transform size, 1 for the smallest transform and 5 for the largest.
*length* is the sub-frames for the *Group* and is given by:
length = 2 ^ (Group - 1).
>> is the shift right operator.
*CurrentAmplitude* and *CurrentPhase* are stored for the next sub-frame. *Envelope[Group][i]* is triangular shaped envelope of appropriate length (*length*) for each group, being zero valued at either end and having a value of 1 in the middle.

Re-synthesis of lower frequencies in the largest three transform sizes via the method described above, causes audible distortion in the output audio, therefore the following empirically based correction is applied to spectral lines less than 60 in groups 3, 4, and 5:

$$\text{xFreq} = \text{Freq} >> (\text{Group} – 1);$$

```
CurrentPhase = Phase – 2 * (2 * xFreq + 1);

f_dlt = Freq – (xFreq << (Group – 1));

for (i = 0; i < length; i = i + 1)
{
        CurrentPhase += 2 * (2 * Freq + 1) / length;
        CurrentAmplitude = Amplitude * Envelope[Group][i];


        Re_Amp = CurrentAmplitude * sin( 2 * Pi * CurrentPhase / 8);
        Im_Amp = CurrentAmplitude * cos( 2 * Pi * CurrentPhase / 8);


        a0 = Re_Amp * CorrCf[f_dlt][0];
        b0 = Im_Amp * CorrCf[f_dlt][0];
        a1 = Re_Amp * CorrCf[f_dlt][1];
        b1 = Im_Amp * CorrCf[f_dlt][1];
        a2 = Re_Amp * CorrCf[f_dlt][2];
        b2 = Im_Amp * CorrCf[f_dlt][2];
        a3 = Re_Amp * CorrCf[f_dlt][3];
        b3 = Im_Amp * CorrCf[f_dlt][3];
        a4 = Re_Amp * CorrCf[f_dlt][4];
        b4 = Im_Amp * CorrCf[f_dlt][4];


        Re[i][abs(xFreq – 2)]  –=     a4;
        Im[i][abs(xFreq – 2)]  –=     b4;
        Re[i][abs(xFreq – 1)]  +=     (a3-a0);
        Im[i][abs(xFreq – 1)]  +=     (b3-b0);
                Re[i][xFreq]         +=     Re_Amp – a2 - a3;
                Im[i][xFreq]         +=     Im_Amp – b2 - b3;
                Re[i][xFreq + 1]     +=     a1 + a4 - Re_Amp;
                Im[i][xFreq + 1]     +=     b1 + b4 - Im_Amp;
                Re[i][xFreq + 2]     +=     a0 - a1;
                Re[i][xFreq + 3]     +=     a2;
                Im[i][xFreq + 3]     +=     a2;
        }
```

where:

> *Amplitude, Freq, Phase, Envelope[Group][i], Group,* and
> *Length* are all as previously defined.
> *CorrCf* is given by Table 2 (Figure 20).
> *abs(val)* is a function which returns the absolute value of val

Since the bit stream does not contain any information as to the number of tonal components encoded, the decoder just reads tone data for each transform size until it runs out of data for that size. Thus, tonal components removed from the bit stream by external means, have no affect on the decoder's ability to handle data still contained in the bit stream. Removing elements from the bit stream just degrades audio quality by the amount of the data component removed. Tonal chunks can also be removed, in which case the decoder does not perform any reconstruction work of tonal components for that transform size.

Inverse Frequency Transform 604

The Inverse Frequency Transform 604 is the inverse of the transform used to create the frequency domain representation in the encoder. The current embodiment employs the inverse hierarchical filterbank described above. Alternately, an Inverse Fast Fourier Transform which is the inverse of the smallest FFT used to extract tones by the encoder provided overlapping FFTs were used at encode time.

Residual Decoder 602

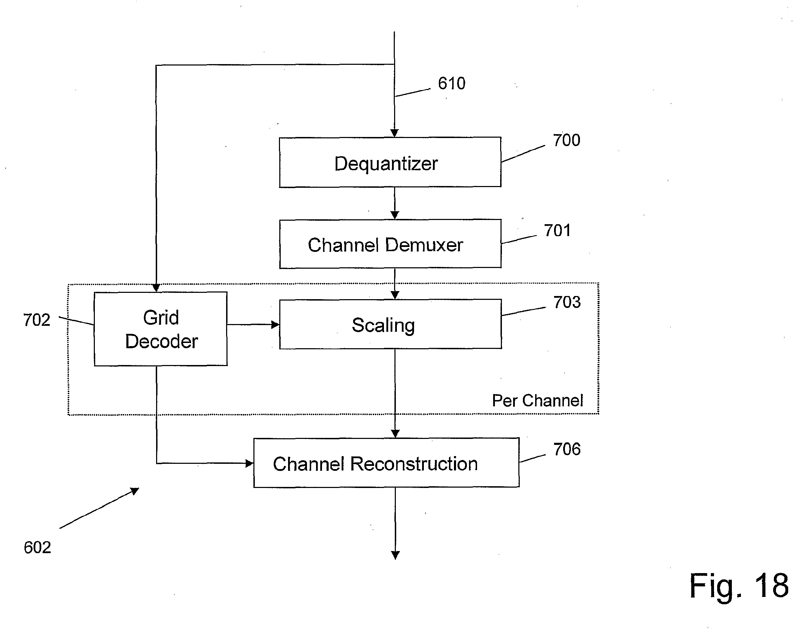

A detailed block diagram of Residual Decoder 602 is shown in Figure 18. Bit stream Parser 600 passes G1 elements from the bit stream to Grid Decoder 702 on line 610. Grid Decoder 702 decodes G1 to recreate G0 which is 32 frequency sub-bands by 64 time intervals. The bit stream contains quantized G1 values and the distances between those values. G1 values from the bit stream are dequantized using the same dequantization table as used to dequantize tonal component amplitudes. Linear interpolation between the values from the bit stream leads to 8 final G1 amplitudes for each G1 sub-band. Sub-bands 0 and 1 of G1 are initialized to zero, the zero values being replaced when sub-band information for these two sub-bands are found in the bit stream. These amplitudes are then weighted into the recreated G0 grid using the mapping weights 1900 obtained from Table 1 in Figure 19. A general formula for G0 is given by:

$$G0_{m,n} = \sum_{k=0}^{10} \left( W_{m,k} \cdot G1_{k,\lfloor n/8 \rfloor} \right)$$

where:

> *m* is the sub-band number
> *W* is the entry from table 1
> *n* is the G0 column number
> *k* spans through 11 G1 subbands

Dequantizer 700

Time samples found by Bit stream Parser 600 are dequantized in Dequantizer 700. Dequantizer 700 dequantizes time samples from the bit stream using the inverse process of the encoder. Time samples from sub-band zero are dequantized to 16 levels, sub-bands 1 and 2 to 8 levels, sub-bands 11 through 25 to three levels, and sub-bands 26 through 31 to 2 levels. Any missing or invalid time samples are replaced with a pseudo-random sequence of values in the range of -1 to 1 having a white-noise spectral energy distribution. This improves scaled bit stream audio quality since such a sequence of values has characteristics that more closely resemble the original signal than replacement with zero values.

Channel Demuxer 701

Secondary channel information in the bit stream is stored as the difference from the primary channel for some sub-bands, depending on flags set in the bit stream. For these sub-bands, Channel Demuxer 701, restores values in the secondary channel from the values in the primary channel and difference values in the bit stream. If secondary channel information is missing the bit stream, secondary channel information can roughly be recovered from the primary channel by duplicating the primary channel information into secondary channels and using the stereo grid, to be subsequently discussed.

Channel Reconstruction 706

Stereo Reconstruction 706 is applied to secondary channels when no secondary channel information (time samples) are found in the bit stream. The stereo grid, reconstructed by Grid Decoder 702, is applied to the secondary time samples, recovered by duplicating the primary channel time sample information, to maintain the original stereo power ratio between channels.

Multichannel Reconstruction

Multichannel Reconstruction 706 is applied to secondary channels when no secondary information (either time samples or grids) for the secondary channels is present in the bit stream. The process is similar to Stereo Reconstruction 706, except that the partial grid reconstructed by Grid Decoder 702, is applied to the time samples of the secondary channel within each channel group, recovered by duplicating primary channel time sample information to maintain proper power level in the secondary channel. The partial grid is applied individually to each secondary channel in the reconstructed channel group following scaling by other scale factor grid(s) including grid G0 in the scaling step 703 by multiplying time samples of Grid G by corresponding elements of the partial grid for each secondary channel. The Grid G0, partial grids may be applied in any order in keeping with the present invention.
While several illustrative embodiments of the invention have been shown and described, numerous variations and alternate embodiments will occur to those skilled in the art. Such variations and alternate embodiments are contemplated, and can be made without departing from the scope of the invention as defined in the appended claims.

**Claims**

1. A method of reconstructing a time-domain output audio signal from an encoded bit stream, comprising:

    receiving a scaled bit stream **(599)** having a predetermined data rate within a given range as a sequence of frames, each frame containing at least one of the following and at least some of the frames containing all of the following (a) a plurality of quantized tonal components **(2407)** representing frequency domain content at different frequency resolutions of an input signal, b) quantized residual time-sample components **(2403)** representing a time-domain residual formed from the difference between reconstructed tonal components and an input signal, and c) scale factor grids **(2404)** representing signal energies of a residual signal formed from the difference between reconstructed tonal components and an input signal, wherein the scale factor grids **(2404)** at least partially span a frequency range of the input signal;
    receiving information **(599)** for each frame about the position of the quantized components and/or grids within the frequency range;
    parsing the frames of the scaled bit stream into the components and grids **(600)**;
    decoding any tonal components to form transform coefficients **(2408)**;
    decoding any time-sample components and any grids **(2401-2405)**;
    multiplying the time-sample components by grid elements to form time-domain samples **(2406)**; and
    applying an inverse hierarchical filterbank **(2400)** to the transform coefficients **(2407)** and time-domain samples **(4002)** to reconstruct a time-domain output audio signal **(614)**.

2. The method of claim 1, wherein the time-domain samples are formed by,
    parsing the bit stream into a scale factor Grid G1(**2404**) and the time-sample components **(2403)**;
    decoding and inverse quantizing grid G1 scale factor grid to produce a G0 scale factor grid **(2405)**; and
    decoding and inverse quantizing the time-sample components, multiplying those time-sample values by G0 scale factor grid values **(2406)** to produce reconstructed time-sample **(4002).**

3. The method of claim 2, wherein the signal is a multichannel signal in which the residual channels have been grouped and encoded, each said frame also containing d) partial grids representing the signal energy ratios of the residual signal channels within channel groups further comprising:

    parsing the bit stream into the partial grids **(508);**

decoding and inverse quantizing **(2401)** the partial grids; and

multiplying the reconstructed time-samples by the partial grid **(508)** applied to each secondary channel in a channel group to produce the reconstructed time-domain samples.

4. The method of claim 1, wherein the input signal is multichannel in which tonal components groups containing a primary and one or more secondary channels, each said frame also containing e) a bitmask associated with the primary channel in each group in which each bit identifies the presence of a secondary channel that has been jointly encoded with the primary channel,

parsing the bit stream into the bitmasks **(3602)**;

decoding the tonal components for the primary channel in each group **(601)**;

decoding the jointly encoded tonal components in each group **(601)**;

for each group, using the bitmask to reconstruct the tonal components for each said secondary channel from the tonal components of primary channel and the jointly encoded tonal components **(601).**

5. The method of claim 4, wherein the secondary channel tonal components are decoded by decoding the difference information between the primary and secondary frequencies, amplitudes and phases being entropy-coded and stored for each secondary channel in which the tonal component is present.

6. The method of claim 1, wherein the inverse hierarchical filterbank **(2400)** reconstructs the output audio signal **(614)** by transforming the time-domain samples ($4002$) into residual transform coefficients **(2411),** combining **(2412)** them with the transform coefficients **(2409)** for a set of tonal components **(2407)** at a low frequency resolution and inverse transforming **(2413)** the combined transform coefficients to form a partially reconstructed output audio signal **(2415),** and repeating the steps on this partially reconstructed output audio signal with the transform coefficients for another set of tonal components at the next highest frequency resolution until the output audio signal **(614)** is reconstructed.

7. The method of claim 6, wherein the time-domain samples are represented as sub-bands, said inverse hierarchical filterbank reconstructing the time-domain output audio signal by:

a) windowing the signal(s) in each of the time-domain sub-bands of the input frame to form windowed time-domain sub-bands **(2410)**;

b) applying a time-to-frequency domain transform to each of the windowed time-domain sub-bands to form transform coefficients **(2411)**;

c) concatenating the resulting transform coefficients to form larger set(s) of the residual transform coefficients **(2411)**;

d) synthesizing the transform coefficients from the set of tonal components **(2409)**;

e) combining the transform coefficients reconstructed from the tonal and time-domain components into a single set of combined transform coefficients **(2412)**;

f) applying an inverse transform to the combined transform coefficients **(2413),** windowing and overlap adding **(2414)** with the previous frame to reconstruct a partially reconstructed time domain signal **(2415);** and

g) applying successive iterations of steps (a) to (f) on the partially reconstructed time domain signal(s) using the next set of tonal components **(2407)** until the time-domain output audio signal **(614)** is reconstructed.

8. The method of claim 6, in which each input frame contains $M_i$ time samples in each of P sub-bands, said inverse hierarchical filterbank performing the following steps:

a) in each sub-band i, buffering and concatenated the $M_i$ previous samples with the current $M_i$ samples to produce $2* M_i$ new samples **(4004)**;

b) in each sub-band i, multiplying the $2* M_i$ sub-band samples by a $2* M_i$ point window function **(4006)**;

c) applying a $(2* M_i)$-point transform to the sub-band samples to produce $M_i$ transform coefficients for each sub-band I **(4008)**;

d) concatenating the $M_i$ transform coefficients for each sub-band i to form a single set of N/2 coefficients **(4010)**;

e) synthesizing tonal transform coefficients from the decoded and inverse quantized set of tonal components and combining them with the concatenated coefficients of the previous step to form a single set of combined concatenated coefficients **(2407,2408,2409,2412)**;

f) applying an N-point inverse transform to the combined concatenated coefficients to produce N samples **(4012)**;

g) multiplying each Frame of N samples by an N-sample window function to produce N windowed samples **(4014)**;

h) overlap adding the resulting windowed samples **(4014)** to produce N/2 new output samples at the given sub-band level as the partially reconstructed output audio signal **(4016);** and

i) repeating steps (a)-(h) on the N/2 new output samples using the next set of tonal components **(2407)** until all sub-bands have been processed and the N original time samples are reconstructed as the output audio signal **(614).**

9.  A decoder for reconstructing a time-domain output audio signal from an encoded bit stream, comprising:

a bit stream parser **(600)** for parsing each frame of a scaled bit stream into its audio components, each frame containing at least one of the following and at least some of the frames containing all of the following (a) a plurality of quantized tonal components representing frequency domain content at different frequency resolutions of an input signal, b) quantized residual time-sample components representing a time-domain residual formed from the difference between reconstructed tonal components and an input signal, and c) scale factor grids representing signal energies of a residual signal formed from the difference between reconstructed tonal components and an input signal;

a residual decoder **(602)** for decoding any time-sample components and any grids to reconstruct time samples;

a tonal decoder **(601)** for decoding any tonal components to form transform coefficients; and

an inverse hierarchical filterbank **(2400)** that reconstructs the output signal by transforming the time samples into residual transform coefficients, combining them with the transform coefficients for a set of the tonal components at a low frequency resolution and inverse transforming the combined transform coefficients to form a partially reconstructed output signal, and repeating the steps on this partially reconstructed output signal with the transform coefficients for another set of tonal components at the next highest frequency resolution until the output audio signal is reconstructed.

10. The decoder of claim 9, wherein each input frame contains $M_i$ time samples in each of P sub-bands, said inverse hierarchical filterbank performing the following steps:

a) in each sub-band i, buffering and concatenated the $M_i$ previous samples with the current $M_i$ samples to produce 2* $M_i$ new samples **(4004);**

b) in each sub-band i, multiplying the 2* $M_i$ sub-band samples by a 2* $M_i$ point window function **(4006);**

c) applying a (2* $M_i$)-point transform to the sub-band samples to produce $M_i$ residual transform coefficients for each sub-band i **(4008);**

d) concatenating the $M_i$ residual transform coefficients for each sub-band i to form a single set of N/2 coefficients **(4010);**

e) synthesizing tonal transform coefficients from the decoded and inverse quantized set of tonal components and combining them with the concatenated residual transform coefficients to form a single set of combined concatenated coefficients **(2407,2408,2409,2412);**

f) applying an N-point inverse transform to the combined concatenated coefficients to produce N samples **(4012);**

g) multiplying each Frame of N samples by an N-sample window function to produce N windowed samples **(4014);**

h) overlap adding the resulting windowed samples **(4014)** to produce N/2 new output samples at the given sub-band level as the partially reconstructed output signal **(4016);** and

i) repeating steps (a)-(h) on the N/2 new output samples using the next set of tonal components **(2407)** until all sub-bands have been processed and the N original time samples are reconstructed as the output signal **(614).**

11. A method of encoding an input audio signal to form a scalable bit stream (116), comprising:

using a hierarchical filterbank (HFB) **(2101a,... 2101e)** to decompose an input audio signal **(100)** into a multi-resolution time/frequency representation;

extracting tonal components at each iteration of the HFB at multiple frequency resolutions from the time/frequency representation **(2109);**

extracting residual components **(2117, 2118, 2119)** from the time/frequency representation by removing tonal components from the input signal to pass a residual signal to the next iteration of the HFB and by extracting the residual components **(2117, 2118, 2119)** from the final residual signal;

ranking the components based on their relative contribution to decoded signal quality **(103,107,109);**

quantizing and encoding the components **(102,107,108);**

forming a master bit stream **(126)** including the ranked quantized components **(109),** and

scaling the master bit stream **(126)** by eliminating a sufficient number of lowest ranked encoded components **(115)** to form the scaled bit stream **(116)** having a data rate less than or approximately equal to a desired data rate,

wherein the components are ranked and quantized with reference to the same masking function or different psychoacoustic criteria, and
wherein the scaled bit stream includes information that indicates the position of the components in the frequency spectrum.

12. The method of claim 11, wherein the components are ranked by first grouping the tonal components into at least one frequency sub-domain **(903,904,905, 906, 907)** at different frequency resolutions and grouping the residual components into at least one residual sub-domain **(908, 909,910)** at different time scales and/or frequency resolutions, ranking the sub-domains based on their relative contribution to decoded signal quality and ranking the components within each sub-domain based on their relative contribution to decoded signal quality.

13. The method of claim 12, further comprising:

    forming the master bit stream **(126)** in which the sub-domains and components within each sub-domain are ordered based on their ranking **(109),** said low ranking components being eliminated by starting with the lowest ranking component in the lowest ranking sub-domain and eliminating components in order until the desired data rate is achieved **(115).**

14. The method of claim 11, wherein the scaled bit stream **(116)** is recorded on or transmitted over a channel having the desired data rate as a constraint.

15. The method of claim 14, wherein the scaled bit stream **(116)** is one of a multiple of scaled bit streams and the data rate of each individual bit stream is controlled independently, with the constraint that the sum of individual data rates must not exceed a maximum total data rate, each said data rate being dynamically controlled in time in accordance with decoded signal quality across all bit streams.

16. The method of claim 11, whereby tonal components that are eliminated to form the scaled bit stream are also removed **(2112)** from the residual signal **(2114).**

17. The method of claim 11, wherein the residual components include time-sample components **(2117)** and scale factor components **(2118, 2119)** that modify the time-sample components at different time scales and/or frequency resolutions.

18. The method of claim 17, wherein the time-sample components are represented by a grid G **(2117)** and the scale factor components comprise a series of one or more grids G0, G1 **(2118, 2119)** at multiple time scales and frequency resolutions that are applied to the time-sample components by dividing the grid G by grid elements of G0, G1 in the time/frequency plane, each grid G0, G1 having a different number of scale factors in time and/or frequency.

19. The method of claim 17, wherein the scale factors are encoded **(107)** by applying a two-dimensional transform to the scale factor components and quantizing the transform coefficients.

20. The method of claim 19, wherein the transform is a two-dimensional Discrete Cosine Transform.

21. A method of claim 11, wherein the HFB decomposes the input audio signal into transform coefficients at successively lower frequency resolution levels at successive iterations, wherein said tonal and residual components are extracted by:

    extracting tonal components **(2109)** from the transform coefficients at each iteration, quantizing **(2110)** and storing the extracted tonal components in a tone list **(2106);**
    removing the tonal components **(2111, 2112)** from the input audio signal to pass a residual signal **(2114)** to the next iteration of the HFB; and
    applying a final inverse transform **(2115)** with relatively lower frequency resolution than the final iteration of the HFB to the residual signal **(113)** to extract the residual components **(2117).**

22. The method of claim 21, further comprising:

    removing some of the tonal components **(114)** from the tone list after the final iteration; and
    locally decoding and inverse quantizing **(104)** the removed quantized tonal components **(114),** and combining **(105)** them with the residual signal **(111)** at the final iteration.

23. The method of claim 22, wherein at least some of the relatively strong tonal components removed from the list are not locally decoded and recombined.

24. The method of claim 21, wherein the tonal components at each frequency resolution are extracted **(2109)** by:

identifying the desired tonal components through application of a perceptual model;
selecting the most perceptually significant of the transform coefficients;
storing parameters of each selected transform coefficient as the tonal component, said parameters including the amplitude, frequency, phase, and position in the frame of the corresponding transform coefficient; and
quantizing and encoding **(2110)** the parameters for each tonal component in the tone list for insertion into the bit stream.

25. The method of claim 21, wherein the residual components include time-sample components represented as a Grid G **(2117)**, the extraction of the residual components further comprises:

constructing one or more scale-factor grids **(2118, 2119)** of different time/frequency resolutions, elements of which represent maximum signal values or signal energies in a time/frequency region;
dividing the elements of time-sample grid G by corresponding elements of the scale-factor grids to produce a scaled time sample grid G **(2120);** and
quantizing and encoding the scaled time-sample grid G **(2122)** and scale-factor grids **(2121)** for insertion into the encoded bit stream.

26. The method of claim 11, wherein the input audio signal is decomposed and the tonal and residual components are extracted by,

(a) buffering samples of the input audio signal into frames of N samples **(2900);**
(b) multiplying the N samples in each frame by an N-sample window function **(2900);**
(c) applying an N-point transform to produce N/2 original transform coefficients **(2902);**
(d) extracting tonal components from the N/2 original transform coefficients **(2109)**, quantizing **(2110)** and storing the extracted tonal components in a tone list **(2106);**
(e) subtracting the tonal components by inverse quantizing **(2111)** and subtracting the resulting tonal transform coefficients from the original transform coefficients **(2112)** to give N/2 residual transform coefficients;
(f) dividing the N/2 residual transform coefficients into P groups of $M_i$ coefficients **(2906),** such that the sum of

$$( \sum_{i=1}^{P} M_i = N/2 ; )$$

the $M_i$ coefficients is N/2

(g) for each of P groups, applying a $(2*M_i)$-point inverse transform to the residual transform coefficients to produce $(2*M_i)$ sub-band samples from each group **(2906);**
(h) in each sub-band, multiplying the $2* M_i$ sub-band samples by a $2* M_i$ point window function; **(2908)**
(i) in each sub-band, overlapping with $M_i$ previous samples and adding corresponding values to produce $M_i$ new samples for each sub-band **(2910);**
(j) repeating steps (a)-(i) on one or more of the sub-bands of $M_i$ new samples using successively smaller transform sizes N **(2912)** until the desired time/transform resolution is attained **(29014);** and
(k) Applying a final inverse transform **(2115)** with relatively lower frequency resolution N to the $M_i$ new samples for each sub-band output at the final iteration to produce subbands of time samples in a grid G of sub-bands and multiple time samples in each sub-band.

27. The method of claim 11, wherein the input audio signal is a multichannel input audio signal, each said tonal component being jointly encoded by forming groups of said channels and for each said group,
Selecting a primary channel and at least one secondary channel, which are identified through a bitmask **(3602)** with each bit identifying the presence of a secondary channel,
Quantizing and encoding the primary channel **(102,108);** and
Quantizing and encoding the difference between the primary and each secondary channel **(102,108).**

28. The method of claim 27, wherein a joint channel mode for encoding each channel group is selected based on a metric that indicates which mode provides the least perceived distortion for the desired data rate in the decoded output signal.

**29.** The method of claim 11, wherein the input audio signal is a multichannel signal, further comprising:

subtracting the extracted tonal components from the input audio signal for each channel to form residual signals **(2109a,..2109e)**);
forming the channels of the residual signal into groups determined by perceptual criteria and coding efficiency **(3702);**
determining primary and secondary channels for each said residual signal group **(3704);**
calculating a partial grid **(508)** to encode relative spatial information between each primary/secondary channel pairing in each residual signal group **(502);**
quantizing and encoding residual components for the primary channel in each group as respective grids G **(2110a);**
quantizing and encoding the partial grid to reduce the required data rate **(2110a);** and
inserting the encoded partial grid and the grid G for each group into the scaled bit stream **(3706).**

**30.** The method of claim 29, wherein the secondary channels are constructed from linear combinations of one or more channels **(3704).**

**31.** A scalable bit stream encoder for encoding an input audio signal and forming a scalable bit stream, comprising:

a hierarchical filterbank (HFB) **(2100)** that decomposes the input audio signal into transform coefficients **(2108)** at successively lower frequency resolution levels and back into time-domain sub-band samples **(2114)** at successively finer time scales at successive iterations;
a tone encoder **(102)** that (a) extracts tonal components **(2109)** from the transform coefficients at each iteration, quantizes **(2110)** and stores them in a tone list **(2106)**, (b) removes the tonal components **(2111, 2112)** from the input audio signal to pass a residual signal **(2114b)** to the next iteration of the HFB and (c) ranks all of the extracted tonal components based on their relative contribution to decoded signal quality;
a residual encoder **(107)** that applies a final inverse transform **(2115)** with relatively lower frequency resolution than the final iteration of the HFB **(2101e)** to the final residual signal **(113)** to extract the residual components **(2117, 2118, 2119)** and ranks the residual components based on their relative contribution to decoded signal quality;
wherein the extracted tonal components and residual components are ranked and quantized with reference to the same masking function or different psychoacoustic criteria;
a bit stream formatter **(109)** that assembles the tonal and residual components on a frame-by-frame bases to form a master bit stream **(126);** and
a scaler **(115)** that eliminates a sufficient number of the lowest ranked encoded components from each frame of the master bit stream to form a scaled bit stream **(116)** having a data rate less than or approximately equal to a desired data rate,

wherein the scaled bit stream includes information that indicates the position of the components in the frequency spectrum.

**32.** The encoder of claim 31, wherein the tone encoder groups the tonal components into frequency sub-domains at different frequency resolutions **(903,904,905, 906, 907)** and ranks the components with each sub-domain, the residual encoder groups the residual components into residual sub-domains at different time scales and/or frequency resolutions **(908, 909,910)** and ranks the components with each sub-domain, and said bit stream formatter ranks the sub-domains based on their relative contribution to decoded signal quality.

**33.** The encoder of claim 32, wherein the bit stream formatter orders the sub-domains and the components within each sub-domain based on their ranking, said scaler **(115)** eliminating said low ranking components being by starting with the lowest ranking component in the lowest ranking sub-domain and eliminating components in order until the desired data rate is achieved.

**34.** The encoder of claim 31, wherein the input audio signal is a multichannel input audio signal, said tone encoder jointly encoded each said tonal components by forming groups of said channels and for each said group,
selecting a primary channel and at least one secondary channel, which are identified through a bitmask **(3602)** with each bit identifying the presence of a secondary channel;
quantizing and encoding the primary channel **(102,108);** and
quantizing and encoding the difference between the primary and each secondary channel **(102,108).**

35. The encoder of claim 31, wherein the input signal is a multichannel audio signal, said residual encoder,
forming the channels of the residual signal into groups determined by perceptual criteria and coding efficiency **(3702);**
determining primary and secondary channels for each said residual signal group **(3704);**
calculating a partial grid **(508)** to encode relative spatial information between each primary/secondary channel pairing in each residual signal group **(502);**
quantizing and encoding residual components for the primary channel in each group as respective grids G **(2110a);**
quantizing and encoding the partial grid to reduce the required data rate **(2110a);** and
inserting the encoded partial grid and the grid G for each group into the scaled bit stream **(3706).**

36. The encoder of claim 31, wherein the residual encoder extracts time-sample components represented by a grid G **(2117)** and a series of one or more scale factor grids G0, G1 **(2118, 2119)** at multiple time and frequency resolutions that are applied to the time-sample components by dividing the grid G by grid elements of G0, G1 in the time/frequency plane **(2120),** each grid G0, G1 having a different number of scale factors in time and/or frequency.

**Patentansprüche**

1. Verfahren zum Rekonstruieren eines Zeitbereichs-Ausgangsaudiosignals von einem codierten Bitstream, das Folgendes umfasst:

   Empfangen eines skalierten Bitstreams (599) mit einer vorbestimmten Datenrate innerhalb eines gegebenen Bereichs als eine Folge von Frames, wobei jedes Frame mindestens ein Element der folgenden enthält und mindestens einige der Frames alle Elemente der folgenden enthalten: (a) eine Vielzahl von quantisierten tonalen Komponenten (2407), die Frequenzbereichsinhalte bei unterschiedlichen Frequenzauflösungen eines Eingangssignals repräsentieren, b) quantisierte Restzeitprobenkomponenten (2403), die einen Zeitbereichsrest repräsentieren, der aus der Differenz zwischen rekonstruierten tonalen Komponenten und einem Eingangssignal gebildet wird, und c) Skalierfaktorraster (2404), die Signalenergien eines Restsignals repräsentieren, das aus der Differenz zwischen rekonstruierten tonalen Komponenten und einem Eingangssignal gebildet wird, wobei die Skalierfaktorraster (2404) zumindest teilweise einen Frequenzbereich des Eingangssignals umspannen;
   Empfangen von Informationen (599) für jedes Frame über die Position der quantisierten Komponenten und/oder Raster innerhalb des Frequenzbereichs;
   Parsen der Frames des skalierten Bitstreams in die Komponenten und Raster (600);
   Decodieren jeglicher tonaler Komponenten zur Bildung von Transformationskoeffizienten (2408);
   Decodieren jeglicher Zeitprobenkomponenten und jeglicher Raster (2401-2405);
   Multiplizieren der Zeitprobenkomponenten mit Rasterelementen zur Bildung von Zeitbereichsproben (2406); und
   Anwenden einer inversen hierarchischen Filterbank (2400) auf die Transformationskoeffizienten (2407) und Zeitbereichsproben (4002) zum Rekonstruieren eines Zeitbereichs-Ausgangsaudiosignals (614).

2. Verfahren nach Anspruch 1, wobei die Zeitbereichsproben durch Folgendes gebildet werden:

   Parsen des Bitstreams in ein Skalierfaktorraster G1 (2404) und die Zeitprobenkomponenten (2403);
   Decodieren und inverses Quantisieren eines G1 Skalierfaktorrasters zum Produzieren eines G0 Skalierfaktorrasters (2405); und
   Decodieren und inverses Quantisieren der Zeitprobenkomponenten, Multiplizieren jener Zeitprobenwerte mit G0 Skalierfaktorrasterwerten (2406) zum Produzieren einer rekonstruierten Zeitprobe (4002).

3. Verfahren nach Anspruch 2, bei dem das Signal ein Mehrkanalsignal ist, in dem die Restkanäle gruppiert und codiert worden sind, und in dem jedes Frame außerdem d) Teilraster enthält, welche die Signalenergieverhältnisse der Restsignalkanäle innerhalb der Kanalgruppen repräsentieren, wobei das Verfahren ferner Folgendes umfasst:

   Parsen des Bitstreams in die Teilraster (508);
   Decodieren und inverses Quantisieren (2401) der Teilraster; und
   Multiplizieren der rekonstruierten Zeitproben mit dem Teilraster (508), das auf jeden sekundären Kanal in einer Kanalgruppe angewandt wird, um die rekonstruierten Zeitbereichsproben zu produzieren.

4. Verfahren nach Anspruch 1, bei dem das Eingangssignal ein Mehrkanalsignal ist, in dem tonale Komponentengruppen einen primären und einen oder mehrere sekundäre Kanäle enthalten, jedes Frame außerdem e) eine mit dem primären Kanal in jeder Gruppe verbundene Bitmaske enthält, in der jedes Bit das Vorhandensein eines sekundären Kanals identifiziert, der gemeinsam mit dem primären Kanal codiert worden ist,

Parsen des Bitstreams in die Bitmasken (3602); Decodieren der tonalen Komponenten für den primären Kanal in jeder Gruppe (601);

Decodieren der gemeinsam codierten tonalen Komponenten in jeder Gruppe (601);

für jede Gruppe, Verwenden einer Bitmaske zum Rekonstruieren der tonalen Komponenten für jeden sekundären Kanal von den tonalen Komponenten des primären Kanals und den gemeinsam codierten tonalen Komponenten (601).

5. Verfahren nach Anspruch 4, bei dem die tonalen Komponenten des sekundären Kanals decodiert werden, indem die Differenzinformationen zwischen den primären und sekundären Frequenzen decodiert werden, wobei Amplituden und Phasen für jeden sekundären Kanal, in dem die tonale Komponente vorhanden ist, entropiecodiert und gespeichert werden.

6. Verfahren nach Anspruch 1, bei dem die inverse hierarchische Filterbank (2400) das Ausgangsaudiosignal (614) wie folgt rekonstruiert: durch Umwandeln der Zeitbereichsproben (4002) in restliche Transformationskoeffizienten (2411), wobei sie mit den Transformationskoeffizienten (2409) für einen Satz von tonalen Komponenten (2407) bei einer niedrigen Frequenzauflösung kombiniert (2412) werden, durch inverses Umwandeln (2413) der kombinierten Transformationskoeffizienten zur Bildung eines teilweise rekonstruierten Ausgangsaudiosignals (2415), und durch Wiederholen der Schritte an diesem teilweise rekonstruierten Ausgangsaudiosignal mit den Transformationskoeffizienten für einen weiteren Satz von tonalen Komponenten bei der nächsthöheren Frequenzauflösung, bis das Ausgangsaudiosignal (614) rekonstruiert ist.

7. Verfahren nach Anspruch 6, bei dem die Zeitbereichsproben als Teilbänder repräsentiert werden und die inverse hierarchische Filterbank das Zeitbereichs-Ausgangsaudiosignal wie folgt rekonstruiert:

a) Fenstern des Signals (der Signale) in jedem der Zeitbereichs-Teilbänder des Eingangsframes zur Bildung von gefensterten Zeitbereichs-Teilbändern (2410);

b) Anwenden einer Zeitbereich-Frequenzbereich-Transformation auf jedes der gefensterten Zeitbereichs-Teilbänder zur Bildung von Transformationskoeffizienten (2411);

c) Verketten der resultierenden Transformationskoeffizienten zur Bildung eines größeren Satzes (mehrerer größerer Sätze) der restlichen Transformationskoeffizienten (2411);

d) Synthetisieren der Transformationskoeffizienten aus dem Satz von tonalen Komponenten (2409);

e) Kombinieren der aus den tonalen und Zeitbereichskomponenten rekonstruierten Transformationskoeffizienten zu einem einzigen Satz von kombinierten Transformationskoeffizienten (2412);

f) Anwenden einer inversen Transformation auf die kombinierten Transformationskoeffizienten (2413), Fenstern und mit dem vorherigen Frame überlappendes Hinzufügen (2414) zum Rekonstruieren eines teilweise rekonstruierten Zeitbereichssignals (2415); und

g) Anwenden von aufeinanderfolgenden Iterationen der Schritte (a) bis (f) auf das (die) teilweise rekonstruierte(n) Zeitbereichssignal(e) unter Verwendung des nächsten Satzes von tonalen Komponenten (2407), bis das Zeitbereichs-Ausgangsaudiosignal (614) rekonstruiert ist.

8. Verfahren nach Anspruch 6, bei dem jedes Eingangsframe $M_i$ Zeitproben in jedem der P Teilbänder enthält, wobei die inverse hierarchische Filterbank die folgenden Schritte durchführt:

a) in jedem Teilband i, Puffern und Verketten der $M_i$ vorherigen Proben mit den aktuellen $M_i$ Proben, um $2*M_i$ neue Proben (4004) zu produzieren;

b) in jedem Teilband i, Multiplizieren der $2*M_i$ Teilbandproben mit einer $2*M_i$ Punktfensterfunktion (4006);

c) Anwenden einer $(2*M_i)$-Punkttransformation auf die Teilbandproben, um $M_i$ Transformationskoeffizienten für jedes Teilband I (4008) zu produzieren;

d) Verketten der $M_i$ Transformationskoeffizienten für jedes Teilband i, um einen einzelnen Satz von N/2 Koeffizienten (4010) zu bilden;

e) Synthetisieren von tonalen Transformationskoeffizienten aus dem decodierten und invers quantisierten Satz von tonalen Komponenten und Kombinieren derselben mit den verketteten Koeffizienten des vorherigen Schritts, um einen einzelnen Satz von kombinierten verketteten Koeffizienten (2407, 2408, 2409, 2412) zu bilden;

f) Anwenden einer inversen N-Punkt-Transformation auf die kombinierten verketteten Koeffizienten, um N Proben (4012) zu produzieren;

g) Multiplizieren jedes Frames von N Proben mit einer N-Proben-Fensterfunktion, um N gefensterte Proben (4014) zu produzieren;

h) Überlappendes Hinzufügen der resultierenden gefensterten Proben (4014), um N/2 neue Ausgangsproben auf der gegebenen Teilbandstufe als teilweise rekonstruiertes Ausgangsaudiosignal (4016) zu produzieren; und
i) Wiederholen der Schritte (a)-(h) an den N/2 neuen Ausgangsproben unter Verwendung des nächsten Satzes von tonalen Komponenten (2407), bis alle Teilbänder verarbeitet worden sind und die N Originalzeitproben als das Ausgangsaudiosignal (614) rekonstruiert sind.

9. Decoder zum Rekonstruieren eines Zeitbereichs-Ausgangsaudiosignals von einem codierten Bitstream, der Folgendes umfasst:

einen Bitstreamparser (600) zum Parsen jedes Frames eines skalierten Bitstreams in seine Audiokomponenten, wobei jedes Frame mindestens ein Element der folgenden enthält und mindestens einige der Frames alle Elemente der folgenden enthalten: (a) eine Vielzahl von quantisierten tonalen Komponenten, die Frequenzbereichsinhalte bei unterschiedlichen Frequenzauflösungen eines Eingangssignals repräsentieren, b) quantisierte Restzeitprobenkomponenten, die einen Zeitbereichsrest repräsentieren, der aus der Differenz zwischen rekonstruierten tonalen Komponenten und einem Eingangssignal gebildet wird, und c) Skalierfaktorraster, die die Signalenergien eines Restsignals repräsentieren, das aus der Differenz zwischen rekonstruierten tonalen Komponenten und einem Eingangssignal gebildet wird;
einen Restdecoder (602) zum Decodieren jeglicher Zeitprobenkomponenten und jeglicher Raster, um Zeitproben zu rekonstruieren;
einen tonalen Decoder (601) zum Decodieren jeglicher tonaler Komponenten, um Transformationskoeffizienten zu bilden; und
eine inverse hierarchische Filterbank (2400), die das Ausgangssignal wie folgt rekonstruiert: durch Umwandeln der Zeitproben in restliche Transformationskoeffizienten, wobei sie mit den Transformationskoeffizienten für einen Satz von tonalen Komponenten bei einer niedrigen Frequenzauflösung kombiniert werden, durch inverses Umwandeln der kombinierten Transformationskoeffizienten zur Bildung eines teilweise rekonstruierten Ausgangssignals, und durch Wiederholen der Schritte an diesem teilweise rekonstruierten Ausgangssignal mit den Transformationskoeffizienten für einen weiteren Satz von tonalen Komponenten bei der nächsthöheren Frequenzauflösung, bis das Ausgangsaudiosignal rekonstruiert ist.

10. Decoder nach Anspruch 9, bei dem jedes Eingangsframe $M_i$ Zeitproben in jedem der P Teilbänder enthält, wobei die inverse hierarchische Filterbank die folgenden Schritte durchführt:

a) in jedem Teilband i, Puffern und Verketten der $M_i$ vorherigen Proben mit den aktuellen $M_i$ Proben, um $2*M_i$ neue Proben (4004) zu produzieren;
b) in jedem Teilband i, Multiplizieren der $2*M_i$ Teilbandproben mit einer $2*M_i$ Punktfensterfunktion (4006);
c) Anwenden einer $(2*M_i)$-Punkttransformation auf die Teilbandproben, um $M_i$ restliche Transformationskoeffizienten für jedes Teilband i (4008) zu produzieren;
d) Verketten der $M_i$ restlichen Transformationskoeffizienten für jedes Teilband i, um einen einzelnen Satz von N/2 Koeffizienten (4010) zu bilden;
e) Synthetisieren von tonalen Transformationskoeffizienten aus dem decodierten und invers quantisierten Satz von tonalen Komponenten und Kombinieren derselben mit den verketteten restlichen Transformationskoeffizienten, um einen einzelnen Satz von kombinierten verketteten Koeffizienten (2407, 2408, 2409, 2412) zu bilden;
f) Anwenden einer inversen N-Punkt-Transformation auf die kombinierten verketteten Koeffizienten, um N Proben (4012) zu produzieren;
g) Multiplizieren jedes Frames von N Proben mit einer N-Proben-Fensterfunktion, um N gefensterte Proben (4014) zu produzieren;
h) Überlappendes Hinzufügen der resultierenden gefensterten Proben (4014), um N/2 neue Ausgangsproben auf der gegebenen Teilbandstufe als teilweise rekonstruiertes Ausgangssignal (4016) zu produzieren; und
i) Wiederholen der Schritte (a)-(h) an den N/2 neuen Ausgangsproben unter Verwendung des nächsten Satzes von tonalen Komponenten (2407), bis alle Teilbänder verarbeitet worden sind und die N Originalzeitproben als das Ausgangssignal (614) rekonstruiert sind.

11. Verfahren zum Codieren eines Eingangsaudiosignals zur Bildung eines skalierbaren Bitstreams (116), das Folgendes umfasst:

Verwenden einer hierarchischen Filterbank (HFB) (2101a,... 2101e), um ein Eingangsaudiosignal (100) in eine Multi-Auflösungs-Zeit/Frequenz-Repräsentation zu zersetzen;
Extrahieren von tonalen Komponenten bei jeder Iteration der HFB bei mehreren Frequenzauflösungen von der Zeit/Frequenz-Repräsentation (2109);
Extrahieren von Restkomponenten (2117, 2118, 2119) von der Zeit/Frequenz-Repräsentation durch Entfernen von tonalen Komponenten aus dem Eingangssignal, um ein Restsignal an die nächste Iteration der HFB weiterzuleiten, und durch Extrahieren der Restkomponenten (2117, 2118, 2119) von dem endgültigen Restsignal;
Einstufen der Komponenten auf der Basis ihres relativen Beitrags zu der decodierten Signalqualität (103, 107, 109);
Quantisieren und Codieren der Komponenten (102, 107, 108);
Bilden eines Master-Bitstreams (126), der die eingestuften quantisierten Komponenten (109) enthält, und Skalieren des Master-Bitstreams (126) durch Eliminieren einer ausreichenden Anzahl von rangniedrigsten codierten Komponenten (115), um den skalierten Bitstream (116) zu bilden, der eine Datenrate von weniger als oder ungefähr gleich einer gewünschten Datenrate aufweist,

wobei die Komponenten unter Bezugnahme auf dieselbe Maskierfunktion oder unterschiedliche psychoakustische Kriterien eingestuft und quantisiert werden, und

wobei der skalierte Bitstream Informationen enthält, welche die Position der Komponenten in dem Frequenzspektrum angeben.

12. Verfahren nach Anspruch 11, bei dem die Komponenten eingestuft werden, indem zuerst die tonalen Komponenten in mindestens einen Frequenz-Unterbereich (903, 904, 905, 906, 907) bei unterschiedlichen Frequenzauflösungen gruppiert werden und die Restkomponenten in mindestens einen restlichen Unterbereich (908, 909, 910) bei unterschiedlichen Zeitskalen und/oder Frequenzauflösungen gruppiert werden, um die Unterbereiche auf der Basis ihres relativen Beitrags zu der decodierten Signalqualität einzustufen und die Komponenten innerhalb jedes Unterbereichs auf der Basis ihres relativen Beitrags zu der decodierten Signalqualität einzustufen.

13. Verfahren nach Anspruch 12, das ferner Folgendes umfasst:

Bilden des Master-Bitstreams (126), in dem die Unterbereiche und Komponenten innerhalb jedes Unterbereichs auf der Basis ihrer Einstufung (109) geordnet sind, wobei die rangniedrigen Komponenten beginnend bei der rangniedrigsten Komponente in dem rangniedrigsten Unterbereich eliminiert werden und die Komponenten der Reihe nach eliminiert werden, bis die gewünschte Datenrate erzielt wird (115).

14. Verfahren nach Anspruch 11, bei dem der skalierte Bitstream (116) auf einem Kanal aufgezeichnet oder über einen Kanal übertragen wird, der die gewünschte Datenrate als Einschränkung aufweist.

15. Verfahren nach Anspruch 14, bei dem der skalierte Bitstream (116) einer von mehreren von skalierten Bitstreams ist und die Datenrate jedes einzelnen Bitstreams unabhängig gesteuert wird, mit der Einschränkung, dass die Summe der individuellen Datenraten eine maximale Gesamtdatenrate nicht überschreiten darf, wobei jede Datenrate im Einklang mit der decodierten Signalqualität über alle Bitstreams in der Zeit dynamisch gesteuert wird.

16. Verfahren nach Anspruch 11, bei dem tonale Komponenten, die eliminiert werden, um den skalierten Bitstream zu bilden, ebenfalls von dem Restsignal (2114) entfernt (2112) werden.

17. Verfahren nach Anspruch 11, bei dem die Restkomponenten Zeitprobenkomponenten (2117) und Skalierfaktorkomponenten (2118, 2119) enthalten, welche die Zeitprobenkomponenten bei unterschiedlichen Zeitskalen und/oder Frequenzauflösungen modifizieren.

18. Verfahren nach Anspruch 17, bei dem die Zeitprobenkomponenten durch ein Raster G (2117) repräsentiert werden und die Skalierfaktorkomponenten eine Reihe von einem oder mehreren Rastern G0, G1 (2118, 2119) bei mehreren Zeitskalen und Frequenzauflösungen umfassen, die auf die Zeitprobenkomponenten angewandt werden, indem das Raster G durch Rasterelemente von G0, G1 in der Zeit/Frequenz-Ebene unterteilt wird, wobei jedes Raster G0, G1 eine unterschiedliche Anzahl von Skalierfaktoren in Zeit und/oder Frequenz aufweist.

19. Verfahren nach Anspruch 17, bei dem die Skalierfaktoren codiert (107) werden, indem eine zweidimensionale Transformation auf die Skalierfaktorkomponenten angewandt und die Transformationskoeffizienten quantisiert werden.

20. Verfahren nach Anspruch 19, bei dem die Transformation eine zweidimensionale diskrete Kosinustransformation ist.

**21.** Verfahren nach Anspruch 11, bei dem die HFB das Eingangsaudiosignal in Transformationskoeffizienten bei sukzessive niedrigeren Frequenzauflösungsstufen bei sukzessiven Iterationen zersetzt, wobei die tonalen und restlichen Komponenten wie folgt extrahiert werden:

Extrahieren der tonalen Komponenten (2109) von den Transformationskoeffizienten bei jeder Iteration, Quantisieren (2110) und Speichern der extrahierten tonalen Komponenten in einer Tonliste (2106);
Entfernen der tonalen Komponenten (2111, 2112) aus dem Eingangsaudiosignal, um ein Restsignal (2114) an die nächste Iteration der HFB weiterzuleiten; und
Anwenden einer letzten inversen Transformation (2115) mit einer relativ niedrigeren Frequenzauflösung als die letzte Iteration der HFB auf das Restsignal (113), um die Restkomponenten (2117) zu extrahieren.

**22.** Verfahren nach Anspruch 21, das ferner Folgendes umfasst:

Entfernen einiger der tonalen Komponenten (114) aus der Tonliste nach der letzten Iteration; und
lokales Decodieren und inverses Quantisieren (104) der entfernten quantisierten tonalen Komponenten (114), und Kombinieren (105) derselben mit dem Restsignal (111) bei der letzten Iteration.

**23.** Verfahren nach Anspruch 22, bei dem mindestens einige der relativ starken tonalen Komponenten, die aus der Liste entfernt wurden, nicht lokal decodiert und rekombiniert werden.

**24.** Verfahren nach Anspruch 21, bei dem die tonalen Komponenten jeder Frequenzauflösung wie folgt extrahiert (2109) werden:

Identifizieren der gewünschten tonalen Komponenten durch Anwendung eines Wahrnehmungsmodells;
Auswählen der wahrnehmungsmäßig signifikantesten der Transformationskoeffizienten;
Speichern der Parameter jedes ausgewählten Transformationskoeffizienten als tonale Komponente, wobei die Parameter die Amplitude, Frequenz, Phase und Position in dem Frame des entsprechenden Transformationskoeffizienten enthalten; und
Quantisieren und Codieren (2110) der Parameter für jede tonale Komponente in der Tonliste in den Bitstream.

**25.** Verfahren nach Anspruch 21, bei dem die Restkomponenten Zeitprobenkomponenten enthalten, die als ein Raster G (2117) repräsentiert werden, wobei die Extraktion der Restkomponenten ferner Folgendes umfasst:

Konstruieren eines oder mehrerer Skalierfaktorraster (2118, 2119) von unterschiedlichen Zeit-/Frequenzauflösungen, deren Elemente maximale Signalwerte oder Signalenergien in einem Zeit-/Frequenzbereich repräsentieren;
Aufteilen der Elemente des Zeitprobenrasters G durch entsprechende Elemente der Skalierfaktorraster, um ein skaliertes Zeitprobenraster G (2120) zu produzieren; und
Quantisieren und Codieren des skalierten Zeitprobenrasters G (2122) und der Skalierfaktorraster (2121) für Einfügung in den codierten Bitstream.

**26.** Verfahren nach Anspruch 11, bei dem das Eingangsaudiosignal zersetzt wird und die tonalen und restlichen Komponenten wie folgt extrahiert werden:

(a) Puffern von Proben des Eingangsaudiosignals in Frames von N Proben (2900);
(b) Multiplizieren der N Proben in jedem Frame mit einer N-Proben-Fensterfunktion (2900);
(c) Anwenden einer N-Punkt-Transformation, um N/2 Original-Transformationskoeffizienten (2902) zu produzieren;
(d) Extrahieren von tonalen Komponenten von den N/2 Original-Transformationskoeffizienten (2109), Quantisieren (2110) und Speichern der extrahierten tonalen Komponenten in einer Tonliste (2106);
(e) Subtrahieren der tonalen Komponenten durch inverses Quantisieren (2111) und Subtrahieren der resultierenden tonalen Transformationskoeffizienten von den Original-Transformationskoeffizienten (2112), um N/2 restliche Transformationskoeffizienten zu geben;
(f) Aufteilen der N/2 restlichen Transformationskoeffizienten in P Gruppen von $M_i$ Koeffizienten (2906), so dass

die Summe der $M_i$ Koeffizienten $N/2$ ($\sum_{i=1}^{P} M_i = N/2$) ist;
(g) für jede der P Gruppen, Anwenden einer inversen (2*$M_i$-Punkt-Transformation auf die restlichen Transfor-

mationskoeffizienten, um (2*$M_i$) Teilbandproben von jeder Gruppe (2906) zu produzieren;

(h) in jedem Teilband, Multiplizieren der 2*$M_i$ Teilbandproben mit einer 2*$M_i$ Punktfensterfunktion (2908);

(i) in jedem Teilband, Überlappen mit $M_i$ vorherigen Proben und Hinzufügen entsprechender Werte, um $M_i$ neue Proben für jedes Teilband (2910) zu produzieren;

(j) Wiederholen der Schritte (a)-(i) an einem oder mehreren der Teilbänder von $M_i$ neuen Proben unter Verwendung von sukzessive kleineren Transformationsgrößen N (2912), bis die gewünschte Zeit-/Transformationsauflösung erzielt wird (29014); und

(k) Anwenden einer letzten inversen Transformation (2115) mit einer relativ niedrigeren Frequenzauflösung N auf die $M_i$ neuen Proben für jedes bei der letzten Iteration ausgegebene Teilband, um Teilbänder von Zeitproben in einem Raster G von Teilbändern und mehreren Zeitproben in jedem Teilband zu produzieren.

27. Verfahren nach Anspruch 11, bei dem das Eingangsaudiosignal ein Mehrkanal-Eingangsaudiosignal ist und jede tonale Komponente gemeinsam codiert wird, indem Gruppen der Kanäle und für jede Gruppe gebildet werden, ein primärer Kanal und mindestens ein sekundärer Kanal ausgewählt wird, die durch eine Bitmaske (3602) identifiziert werden, wobei jedes Bit das Vorhandensein eines sekundären Kanals identifiziert,
der primäre Kanal quantisiert und codiert wird (102, 108); und
die Differenz zwischen dem primären und jedem sekundären Kanal quantisiert und codiert wird (102, 108).

28. Verfahren nach Anspruch 27, bei dem ein gemeinsamer Kanalmodus zum Codieren jeder Kanalgruppe auf der Basis einer Metrik ausgewählt wird, die angibt, welcher Modus die geringste wahrgenommene Verzerrung für die gewünschte Datenrate in dem decodierten Ausgangssignal liefert.

29. Verfahren nach Anspruch 11, bei dem das Eingangsaudiosignal ein Mehrkanalsignal ist, das ferner Folgendes umfasst:

Subtrahieren der extrahierten tonalen Komponenten von dem Eingangsaudiosignal für jeden Kanal, um Restsignale (2109a,..2109e) zu bilden;
Bilden der Kanäle des Restsignals zu Gruppen, die durch perzeptuelle Kriterien und Codierungseffizienz bestimmt werden (3702);
Bestimmen der primären und sekundären Kanäle für jede Restsignalgruppe (3704);
Berechnen eines Teilrasters (508), um relative räumliche Informationen zwischen jeder primären/sekundären Kanalpaarung in jeder Restsignalgruppe (502) zu codieren;
Quantisieren und Codieren von Restkomponenten für den primären Kanal in jeder Gruppe als jeweilige Raster G (2110a);
Quantisieren und Codieren des Teilrasters, um die erforderliche Datenrate (2110a) zu reduzieren; und
Einfügen des codierten Teilrasters und des Rasters G für jede Gruppe in den skalierten Bitstream (3706).

30. Verfahren nach Anspruch 29, bei dem die sekundären Kanäle aus linearen Kombinationen eines oder mehrerer Kanäle (3704) konstruiert werden.

31. Skalierbarer Bitstreamcodierer zum Codieren eines Eingangsaudiosignals und Bilden eines skalierbaren Bitstreams, der Folgendes umfasst:

eine hierarchische Filterbank (HFB) (2100), die das Eingangsaudiosignal in Transformationskoeffizienten (2108) bei sukzessive niedrigeren Frequenzauflösungsstufen und zurück in Zeitbereichs-Teilbandproben (2114) bei sukzessive feineren Zeitskalen bei sukzessiven Iterationen zersetzt;
einen Toncodierer (102), der (a) tonale Komponenten (2109) bei jeder Iteration von den Transformationskoeffizienten extrahiert, diese quantisiert (2110) und in einer Tonliste (2106) speichert, (b) die tonalen Komponenten (2111, 2112) von dem Eingangsaudiosignal entfernt, um ein Restsignal (2114b) zu der nächsten Iteration der HFB weiterzuleiten, und (c) alle der extrahierten tonalen Komponenten auf der Basis ihres relativen Beitrags zu der decodierten Signalqualität einstuft;
einen Restcodierer (107), der eine letzte inverse Transformation (2115) mit einer relativ niedrigeren Frequenzauflösung als die letzte Iteration der HFB (2101e) auf das letzte Restsignal (113) anwendet, um die Restkomponenten (2117, 2118, 2119) zu extrahieren, und die Restkomponenten auf der Basis ihres relativen Beitrags zu der decodierten Signalqualität einstuft;
wobei die extrahierten tonalen Komponenten und Restkomponenten unter Bezugnahme auf dieselbe Maskierfunktion oder unterschiedliche psychoakustische Kriterien eingestuft und quantisiert werden;
einen Bitstream-Formatierer (109), der die tonalen und restlichen Komponenten auf einer Frame-zu-Frame-Basis zusammenstellt, um einen Master-Bitstream (126) zu bilden; und

einen Skalierer (115), der eine ausreichende Anzahl von rangniedrigsten codierten Komponenten von jedem Frame des Master-Bitstreams eliminiert, um einen skalierten Bitstream (116) zu bilden, der eine Datenrate von weniger als oder ungefähr gleich einer gewünschten Datenrate aufweist,

wobei der skalierte Bitstream Informationen enthält, welche die Position der Komponenten in dem Frequenzspektrum angeben.

32. Codierer nach Anspruch 31, bei dem der Toncodierer die tonalen Komponenten bei unterschiedlichen Frequenzauflösungen (903, 904, 905, 906, 907) zu Frequenz-Unterbereichen gruppiert und die Komponenten mit jedem Unterbereich einstuft, der Restcodierer die Restkomponenten bei unterschiedlichen Zeitskalen und/oder Frequenzauflösungen (908, 909, 910) zu restlichen Unterbereichen gruppiert und die Komponenten mit jedem Unterbereich einstuft, und der Bitstream-Formatierer die Unterbereiche auf der Basis ihres relativen Beitrags zu der decodierten Signalqualität einstuft.

33. Codierer nach Anspruch 32, bei dem der Bitstream-Formatierer die Unterbereiche und die Komponenten innerhalb jedes Unterbereichs auf der Basis ihrer Einstufung ordnet, der Skalierer (115) die rangniedrigen Komponenten, beginnend bei der rangniedrigsten Komponente in dem rangniedrigsten Unterbereich, eliminiert und die Komponenten der Reihe nach eliminiert, bis die gewünschte Datenrate erzielt wird.

34. Codierer nach Anspruch 31, bei dem das Eingangsaudiosignal ein Mehrkanal-Eingangsaudiosignal ist, der Toncodierer jede tonale Komponente gemeinsam codiert, indem er Gruppen der Kanäle und für jede Gruppe bildet, einen primären Kanal und mindestens einen sekundärer Kanal auswählt, die durch eine Bitmaske (3602) identifiziert werden, wobei jedes Bit das Vorhandensein eines sekundären Kanals identifiziert;

der primäre Kanal quantisiert und codiert wird (102, 108); und

die Differenz zwischen dem primären und jedem sekundären Kanal quantisiert und codiert wird (102, 108) .

35. Codierer nach Anspruch 31, bei dem das Eingangssignal ein Mehrkanal-Audiosignal ist und der Restcodierer Folgendes umfasst:

Bilden der Kanäle des Restsignals zu Gruppen, die durch perzeptuelle Kriterien und Codierungseffizienz bestimmt werden (3702);

Bestimmen der primären und sekundären Kanäle für jede Restsignalgruppe (3704);

Berechnen eines Teilrasters (508), um relative räumliche Informationen zwischen jeder primären/sekundären Kanalpaarung in jeder Restsignalgruppe (502) zu codieren;

Quantisieren und Codieren von Restkomponenten für den primären Kanal in jeder Gruppe als jeweilige Raster G (2110a);

Quantisieren und Codieren des Teilrasters, um die erforderliche Datenrate (2110a) zu reduzieren; und

Einfügen des codierten Teilrasters und des Rasters G für jede Gruppe in den skalierten Bitstream (3706).

36. Codierer nach Anspruch 31, bei dem der Restcodierer Zeitprobenkomponenten extrahiert, die durch ein Raster G (2117) und eine Reihe von einem oder mehreren Skalierfaktorrastern G0, G1 (2118, 2119) bei mehreren Zeit- und Frequenzauflösungen repräsentiert werden, die auf die Zeitprobenkomponenten angewandt werden, indem das Raster G durch Rasterelemente von G0, G1 in der Zeit/Frequenz-Ebene (2120) unterteilt wird, wobei jedes Raster G0, G1 eine unterschiedliche Anzahl von Skalierfaktoren in Zeit und/oder Frequenz aufweist.

**Revendications**

1. Procédé de reconstruction d'un signal audio de sortie dans le domaine temporel à partir d'un train de bits codé, comprenant :

la réception d'un train de bits échelonné (599) ayant un débit de données prédéterminé dans une plage donnée sous la forme d'une séquence de trames, chaque trame contenant au moins l'un des éléments suivants et au moins certaines des trames contenant tous les éléments suivants : a) une pluralité de composantes tonales quantifiées (2407) représentant un contenu dans le domaine fréquentiel à différentes résolutions en fréquence d'un signal d'entrée, b) des composantes résiduelles quantifiées d'échantillon temporel (2403) représentant une composante résiduelle dans le domaine temporel formée à partir de la différence entre des composantes tonales reconstruites et un signal d'entrée, et c) des grilles de facteurs d'échelle (2404) représentant les énergies de signal d'un signal résiduel formé par la différence entre des composantes tonales reconstruites et un signal d'entrée, les grilles de facteurs d'échelle (2404) couvrant au moins partiellement une gamme de fréquence du signal d'entrée ;

la réception d'informations (599) pour chaque trame sur la position des composantes quantifiées et/ou des grilles dans la gamme de fréquences ;

l'analyse des trames du train de bits échelonné dans les composantes et les grilles (600) ;

le décodage de toute composante tonale pour former des coefficients de transformation (2408) ;

le décodage de toute composante d'échantillon temporel et de toute grille (2401-2405) ;

la multiplication des composantes de l'échantillon temporel par les éléments de la grille pour former des échantillons dans le domaine temporel (2406) ; et

l'application d'un banc de filtre hiérarchique inverse (2400) aux coefficients de transformation (2407) et aux échantillons dans le domaine temporel (4002) pour reconstruire un signal audio de sortie dans le domaine temporel (614).

2. Procédé selon la revendication 1, les échantillons dans le domaine temporel étant formés par :

l'analyse du train de bits dans une grille de facteur d'échelle G1(2404) et les composantes d'échantillon temporel (2403) ;

le décodage et la quantification inverse de la grille de facteur d'échelle G1 pour produire une grille de facteur d'échelle G0 (2405) ; et

le décodage et la quantification inverse des composantes de l'échantillon temporel, en multipliant ces valeurs d'échantillon temporel par des valeurs de grille de facteur d'échelle G0 (2406) pour produire un échantillon temporel reconstruit (4002).

3. Procédé selon la revendication 2, le signal étant un signal multicanal dans lequel les canaux résiduels ont été groupés et codés, chacune desdites trames contenant également d) des grilles partielles représentant les rapports d'énergie de signal des canaux de signal résiduels dans des groupes de canaux comprenant en outre :

l'analyse du train de bits dans les grilles partielles (508) ;

le décodage et la quantification inverse (2401) des grilles partielles ; et

la multiplication des échantillons temporels reconstruits par la grille partielle (508) appliquée à chaque canal secondaire dans un groupe de canaux pour produire les échantillons reconstruits dans le domaine temporel.

4. Procédé selon la revendication 1, le signal d'entrée étant un signal multicanal dans lequel des groupes de composantes tonales contenant un canal primaire et un ou plusieurs canaux secondaires, chacune desdites trames contenant également e) un masque de bits associé au canal primaire dans chaque groupe dans lequel chaque bit identifie la présence d'un canal secondaire qui a été codé conjointement avec le canal primaire,

l'analyse du train de bits dans les masques de bits (3602) ;

le décodage des composantes tonales du canal primaire dans chaque groupe (601) ;

le décodage des composantes tonales codées conjointement dans chaque groupe (601) ;

pour chaque groupe, l'utilisation du masque binaire pour reconstruire les composantes tonales pour chacun desdits canaux secondaires à partir des composantes tonales du canal primaire et des composantes tonales codées conjointement (601).

5. Procédé selon la revendication 4, les composantes tonales du canal secondaire étant décodées en décodant l'information de différence entre les fréquences primaires et secondaires, les amplitudes et les phases étant codées par entropie et stockées pour chaque canal secondaire dans lequel la composante tonale est présente.

6. Procédé selon la revendication 1, le banc de filtre hiérarchique inverse (2400) reconstruisant le signal audio de sortie (614) en transformant les échantillons dans le domaine temporel (4002) en coefficients de transformation résiduels (2411), en les combinant (2412) avec les coefficients de transformation (2409) pour un ensemble de composantes tonales (2407) à une résolution basse fréquence et en réalisant une transformation inverse (2413) des coefficients de transformation combinés pour former un signal audio de sortie partiellement reconstruit (2415), et en répétant les étapes sur ce signal audio de sortie partiellement reconstruit avec les coefficients de transformation pour un autre ensemble de composantes tonales à la résolution de fréquence la plus élevée suivante jusqu'à ce que le signal audio de sortie (614) soit reconstruit.

**7.** Procédé selon la revendication 6, les échantillons dans le domaine temporel étant représentés sous forme de sous-bandes, ledit banc de filtre hiérarchique inverse reconstruisant le signal audio de sortie dans le domaine temporel par :

a) le fenêtrage du ou des signaux dans chacune des sous-bandes dans le domaine temporel de la trame d'entrée pour former des sous-bandes fenêtrées dans le domaine temporel (2410) ;
b) l'application d'une transformation de domaine temps-fréquence à chacune des sous-bandes fenêtrées dans le domaine temporel pour former des coefficients de transformation (2411) ;
c) la concaténation des coefficients de transformation résultants pour former un ou plusieurs ensembles plus grands des coefficients de transformation résiduels (2411) ;
d) la synthétisation des coefficients de transformation à partir de l'ensemble des composantes tonales (2409) ;
e) la combinaison des coefficients de transformation reconstruits à partir des composantes tonales et temporelles en un ensemble unique de coefficients de transformation combinés (2412) ;
f) l'application d'une transformation inverse aux coefficients de transformation combinés (2413), le fenêtrage et l'ajout superposé (2414) avec la trame précédente pour reconstruire un signal dans le domaine temporel partiellement reconstruit (2415) ; et
g) l'application d'itérations successives des étapes a) à f) sur le ou les signaux dans le domaine temporel partiellement reconstruits en utilisant l'ensemble suivant de composantes tonales (2407) jusqu'à ce que le signal audio de sortie dans le domaine temporel (614) soit reconstruit.

**8.** Procédé selon la revendication 6, chaque trame d'entrée contenant $M_i$ échantillons temporels dans chacune des P sous-bandes, ledit banc de filtre hiérarchique inverse effectuant les étapes suivantes :

a) dans chaque sous-bande i, la mise en mémoire tampon et la concaténation des $M_i$ échantillons précédents avec les $M_i$ échantillons actuels pour produire $2*M_i$ nouveaux échantillons (4004) ;
b) dans chaque sous-bande i, la multiplication des $2*M_i$ échantillons de la sous-bande par une fonction de fenêtre de $2*M_i$ points (4006) ;
c) l'application d'une transformation à $(2*M_i)$ points aux échantillons de sous-bandes pour produire $M_i$ coefficients de transformation pour chaque sous-bande I (4008) ;
d) la concaténation des $M_i$ coefficients de transformation pour chaque sous-bande i pour former un ensemble unique de N/2 coefficients (4010) ;
e) la synthétisation de coefficients de transformation tonale à partir de l'ensemble décodé et quantifié de manière inverse des composantes tonales et leur combinaison avec les coefficients concaténés de l'étape précédente pour former un ensemble unique de coefficients concaténés combinés (2407, 2408, 2409, 2412) ;
f) l'application d'une transformation inverse à N points aux coefficients concaténés combinés pour produire N échantillons (4012) ;
g) la multiplication de chaque trame de N échantillons par une fonction de fenêtre à N échantillons pour produire N échantillons fenêtrés (4014) ;
h) l'ajout superposé des échantillons fenêtrés résultants (4014) pour produire N/2 nouveaux échantillons de sortie au niveau de sous-bande donné comme signal audio de sortie partiellement reconstruit (4016) ; et
i) la répétition des étapes a) à h) sur les N/2 nouveaux échantillons de sortie en utilisant l'ensemble suivant de composantes tonales (2407) jusqu'à ce que toutes les sous-bandes aient été traitées et que les N échantillons temporels originaux soient reconstruits comme signal audio de sortie (614).

**9.** Décodeur pour reconstruire un signal audio de sortie dans le domaine temporel à partir d'un train de bits codé, comprenant :

un analyseur de train de bits (600) pour analyser chaque trame d'un train de bits échelonné en ses composantes audio, chaque trame contenant au moins l'un des éléments suivants et au moins certaines des trames contenant tous les éléments suivants : a) une pluralité de composantes tonales quantifiées représentant un contenu dans le domaine fréquentiel à différentes résolutions de fréquence d'un signal d'entrée, b) des composantes résiduelles quantifiées d'échantillon temporel représentant une composante résiduelle dans le domaine temporel formée par la différence entre des composantes tonales reconstruites et un signal d'entrée, et c) des grilles de facteurs d'échelle représentant les énergies de signal d'un signal résiduel formé par la différence entre des composantes tonales reconstruites et un signal d'entrée ;
un décodeur résiduel (602) pour décoder toute composante d'échantillon temporel et toute grille pour reconstruire des échantillons temporels ;
un décodeur tonal (601) pour décoder toute composante tonale afin de former des coefficients de transformation ; et

un banc de filtre hiérarchique inverse (2400) qui reconstruit le signal de sortie en transformant les échantillons temporels en coefficients de transformation résiduels, en les combinant avec les coefficients de transformation pour un ensemble des composantes tonales à une résolution basse fréquence et en réalisant une transformation inverse des coefficients de transformation combinés pour former un signal de sortie partiellement reconstruit, et en répétant les étapes sur ce signal de sortie partiellement reconstruit avec les coefficients de transformation pour un autre ensemble de composantes tonales à la résolution haute fréquence suivante jusqu'à la reconstruction du signal audio de sortie.

**10.** Décodeur selon la revendication 9, chaque trame d'entrée contenant $M_i$ échantillons temporels dans chacune des P sous-bandes, ledit banc de filtre hiérarchique inverse effectuant les étapes suivantes :

a) dans chaque sous-bande i, la mise en mémoire tampon et la concaténation des $M_i$ échantillons précédents avec les $M_i$ échantillons actuels pour produire $2*M_i$ nouveaux échantillons (4004) ;
b) dans chaque sous-bande i, la multiplication des $2*M_i$ échantillons de la sous-bande par une fonction de fenêtre de $2*M_i$ points (4006) ;
c) l'application d'une transformation à $(2*M_i)$ points aux échantillons de sous-bandes pour produire $M_i$ coefficients de transformation résiduels pour chaque sous-bande i (4008) ;
d) la concaténation des $M_i$ coefficients de transformation résiduels pour chaque sous-bande i pour former un ensemble unique de N/2 coefficients (4010) ;
e) la synthétisation de coefficients de transformation tonale à partir de l'ensemble décodé et quantifié de manière inverse des composantes tonales et leur combinaison avec les coefficients de transformation résiduels concaténés pour former un ensemble unique de coefficients concaténés combinés (2407, 2408, 2409, 2412) ;
f) l'application d'une transformation inverse à N points aux coefficients concaténés combinés pour produire N échantillons (4012) ;
g) la multiplication de chaque trame de N échantillons par une fonction de fenêtre à N échantillons pour produire N échantillons fenêtrés (4014) ;
h) l'ajout superposé des échantillons fenêtrés résultants (4014) pour produire N/2 nouveaux échantillons de sortie au niveau de sous-bande donné comme signal de sortie partiellement reconstruit (4016) ; et
i) la répétition des étapes a) à h) sur les N/2 nouveaux échantillons de sortie en utilisant l'ensemble suivant de composantes tonales (2407) jusqu'à ce que toutes les sous-bandes aient été traitées et que les N échantillons temporels originaux soient reconstruits comme signal de sortie (614).

**11.** Procédé de codage d'un signal audio d'entrée pour former un train de bits échelonnable (116) comprenant :

l'utilisation d'un banc de filtre hiérarchique (HFB) (2101a, ...2101e) pour décomposer un signal audio d'entrée (100) en une représentation temps/fréquence multirésolution ;
l'extraction de composantes tonales à chaque itération du HFB à des résolutions de fréquences multiples à partir de la représentation temps/fréquence (2109) ;
l'extraction de composantes résiduelles (2117, 2118, 2119) à partir de la représentation temps/fréquence en retirant les composantes tonales du signal d'entrée pour passer un signal résiduel à l'itération suivante du HFB et en extrayant les composantes résiduelles (2117, 2118, 2119) du signal résiduel final ;
le classement des composantes sur la base de leur contribution relative à la qualité du signal décodé (103, 107, 109) ;
la quantification et le codage des composantes (102, 107, 108) ;
la formation d'un train de bits maître (126) comprenant les composantes quantifiées classées (109), et
l'échelonnage du train de bits maître (126) en éliminant un nombre suffisant de composantes codées de rang le plus bas (115) pour former le train de bits échelonné (116) ayant un débit de données inférieur ou approximativement égal à un débit de données souhaité,

les composantes étant classées et quantifiées en référence à la même fonction de masquage ou à des critères psychoacoustiques différents, et
le train de bits échelonné comprenant des informations qui indiquent la position des composantes dans le spectre de fréquences.

**12.** Procédé selon la revendication 11, les composantes étant classées en groupant d'abord les composantes tonales en au moins un sous-domaine de fréquence (903, 904, 905, 906, 907) à différentes résolutions de fréquence et en groupant les composantes résiduelles en au moins un sous-domaine résiduel (908, 909, 910) à différentes échelles de temps et/ou résolutions de fréquence, en classant les sous-domaines sur la base de leur contribution relative à la qualité du signal décodé et en classant les composantes dans chaque sous-domaine sur la base de leur contribution relative à la qualité du signal décodé.

**13.** Procédé selon la revendication 12, comprenant en outre :

la formation du train de bits maître (126) dans lequel les sous-domaines et les composantes à l'intérieur de chaque sous-domaine sont ordonnés en fonction de leur classement (109), lesdites composantes de rang inférieur étant éliminées en commençant par la composante de rang le plus bas dans le sous-domaine de rang inférieur et en éliminant les composantes dans l'ordre jusqu'à atteindre le débit de données souhaité (115).

**14.** Procédé selon la revendication 11, le train de bits échelonné (116) étant enregistré ou transmis sur un canal ayant le débit de données souhaité comme contrainte.

**15.** Procédé selon la revendication 14, le train de bits échelonné (116) étant l'un parmi de multiples trains de bits échelonnés et le débit de données de chaque train de bits individuel étant commandé indépendamment, avec la contrainte que la somme des débits de données individuels ne doit pas dépasser un débit total maximal, chaque dit débit de données étant commandé de manière dynamique dans le temps conformément à la qualité du signal décodé dans tous les trains de bits.

**16.** Procédé selon la revendication 11, des composantes tonales qui sont éliminées pour former le train de bits échelonné étant également retirées (2112) du signal résiduel (2114).

**17.** Procédé selon la revendication 11, les composantes résiduelles comprenant des composantes d'échantillon temporel (2117) et des composantes de facteur d'échelle (2118, 2119) qui modifient les composantes d'échantillon temporel à différentes échelles de temps et/ou résolutions en fréquence.

**18.** Procédé selon la revendication 17, les composantes d'échantillon temporel étant représentées par une grille G (2117) et les composantes de facteur d'échelle comprenant une série d'une ou plusieurs grilles G0, G1 (2118, 2119) à échelles de temps et résolutions de fréquence multiples qui sont appliquées aux composantes d'échantillon temporel en divisant la grille G par des éléments de grille G0, G1 dans le plan temps/ fréquence, chaque grille G0, G1 ayant un nombre différent de facteurs d'échelle en temps et/ou fréquence.

**19.** Procédé selon la revendication 17, les facteurs d'échelle étant codés (107) en appliquant une transformation bidimensionnelle aux composantes des facteurs d'échelle et en quantifiant les coefficients de transformation.

**20.** Procédé selon la revendication 19, la transformation étant une transformation discrète bidimensionnelle en cosinus.

**21.** Procédé selon la revendication 11, le HFB décomposant le signal audio d'entrée en coefficients de transformation à des niveaux de résolution de fréquence successivement inférieurs à des itérations successives, lesdites composantes tonales et résiduelles étant extraites par :

l'extraction des composantes tonales (2109) des coefficients de transformation à chaque itération, la quantification (2110) et le stockage des composantes tonales extraites dans une liste de tonalités (2106) ;
le retrait des composantes tonales (2111, 2112) du signal audio d'entrée pour passer un signal résiduel (2114) à l'itération suivante du HFB ; et
l'application d'une transformation inverse finale (2115) avec une résolution en fréquence relativement inférieure à celle de l'itération finale du HFB au signal résiduel (113) pour extraire les composantes résiduelles (2117).

**22.** Procédé selon la revendication 21, comprenant en outre :

le retrait de certaines des composantes tonales (114) de la liste des tonalités après l'itération finale ; et
le décodage local et la quantification inverse (104) des composantes tonales quantifiées retirées (114) et leur combinaison (105) avec le signal résiduel (111) à l'itération finale.

**23.** Procédé selon la revendication 22, au moins certaines des composantes tonales relativement fortes retirées de la liste n'étant pas décodées et recombinées localement.

**24.** Procédé selon la revendication 21, les composantes tonales à chaque résolution de fréquence étant extraites (2109) par :

> l'identification des composantes tonales souhaitées par l'application d'un modèle perceptuel ;
> la sélection du plus significatif des coefficients de transformation ;
> le stockage des paramètres de chaque coefficient de transformation sélectionné en tant que composante tonale, lesdits paramètres comprenant l'amplitude, la fréquence, la phase et la position dans la trame du coefficient de transformation correspondant ; et
> la quantification et le codage (2110) des paramètres pour chaque composante tonale de la liste des tonalités à insérer dans le train de bits.

25. Procédé selon la revendication 21, les composantes résiduelles comprenant des composantes d'échantillon temporel représentées sous la forme d'une grille G (2117), l'extraction des composantes résiduelles comprenant en outre :

> la construction d'une ou plusieurs grilles de facteurs d'échelle (2118, 2119) de différentes résolutions temps/fréquence, dont les éléments représentent des valeurs maximales de signal ou des énergies de signal dans une région temps/fréquence ;
> la division des éléments de la grille d'échantillon temporel G par les éléments correspondants des grilles de facteurs d'échelle pour produire une grille d'échantillon temporel G échelonné (2120) ; et
> la quantification et le codage de la grille d'échantillon temporel échelonné G (2122) et des grilles de facteurs d'échelle (2121) pour insertion dans le train de bits codé.

26. Procédé selon la revendication 11, le signal audio d'entrée étant décomposé et les composantes tonales et résiduelles étant extraites par :

> (a) la mise en mémoire tampon d'échantillons du signal audio d'entrée dans des trames de N échantillons (2900) ;
> (b) la multiplication des N échantillons dans chaque trame par une fonction de fenêtre à N échantillons (2900) ;
> (c) l'application d'une transformation à N points pour produire N/2 coefficients de transformation originaux (2902) ;
> (d) l'extraction de composantes tonales des N/2 coefficients de transformation originaux (2109), la quantification (2110) et le stockage des composantes tonales extraites dans une liste de tonalités (2106) ;
> (e) la soustraction des composantes tonales par quantification inverse (2111) et la soustraction des coefficients de transformation tonale résultants des coefficients de transformation originaux (2112) pour donner N/2 coefficients de transformation résiduels ;
> (f) la division des N/2 coefficients de transformation résiduels en P groupes de $M_i$ coefficients (2906), de sorte que la somme des $M_i$ coefficients soit $N/2$ $(\sum_{i=1}^{P} M_i = N/2 \; ; \;)$
> (g) pour chacun des P groupes, l'application d'une transformation inverse à ($2*M_i$) points aux coefficients de transformation résiduels pour produire ($2*M_i$) échantillons de sous-bandes de chaque groupe (2906) ;
> (h) dans chaque sous-bande, la multiplication des $2*M_i$ échantillons de sous-bande par une fonction de fenêtre de $2*M_i$ point (2908) ;
> (i) dans chaque sous-bande, la superposition avec $M_i$ échantillons précédents et l'ajout des valeurs correspondantes pour produire $M_i$ nouveaux échantillons pour chaque sous-bande (2910) ;
> (j) la répétition des étapes (a) à (i) sur une ou plusieurs sous-bandes de $M_i$ nouveaux échantillons en utilisant successivement des tailles de transformation N (2912) plus petites jusqu'à ce que la résolution temps/transformation souhaitée soit atteinte (29014) ; et
> (k) l'application d'une transformation inverse finale (2115) avec une résolution de fréquence N relativement inférieure aux $M_i$ nouveaux échantillons pour chaque sortie de sous-bande à l'itération finale pour produire des sous-bandes d'échantillons temporels dans une grille G de sous-bandes et de multiples échantillons temporels dans chaque sous-bande.

27. Procédé selon la revendication 11, le signal audio d'entrée étant un signal audio d'entrée multicanal, chacune desdites composantes tonales étant codée conjointement en formant des groupes desdits canaux et pour chacun desdits groupes :

> la sélection d'un canal primaire et d'au moins un canal secondaire, qui sont identifiés par un masque de bits (3602), chaque bit identifiant la présence d'un canal secondaire,
la quantification et le codage du canal primaire (102, 108) ; et
la quantification et le codage de la différence entre le canal primaire et chaque canal secondaire (102, 108) .

**28.** Procédé selon la revendication 27, un mode de canal commun pour coder chaque groupe de canaux étant sélectionné sur la base d'une métrique qui indique quel mode fournit la distorsion la moins perçue pour le débit de données souhaité dans le signal de sortie décodé.

**29.** Procédé selon la revendication 11, le signal audio d'entrée étant un signal multicanal, comprenant en outre :

la soustraction des composantes tonales extraites du signal audio d'entrée pour chaque canal afin de former des signaux résiduels (2109a, ...2109e) ;
la formation des canaux du signal résiduel en groupes déterminés par des critères de perception et d'efficacité de codage (3702) ;
la détermination de canaux primaires et secondaires pour chacun desdits groupes de signaux résiduels (3704) ;
le calcul d'une grille partielle (508) pour coder des informations spatiales relatives entre chaque paire de canaux primaire/secondaire dans chaque groupe de signaux résiduels (502) ;
la quantification et le codage des composantes résiduelles pour le canal primaire dans chaque groupe sous forme de grilles respectives G (2110a) ;
la quantification et le codage de la grille partielle pour réduire le débit de données requis (2110a) ; et
l'insertion de la grille partielle codée et de la grille G pour chaque groupe dans le train de bits échelonné (3706).

**30.** Procédé selon la revendication 29, les canaux secondaires étant construits à partir de combinaisons linéaires d'un ou plusieurs canaux (3704).

**31.** Codeur de train de bits échelonnable pour coder un signal audio d'entrée et former un train de bits échelonnable, comprenant :

un banc de filtre hiérarchique (HFB) (2100) qui décompose le signal audio d'entrée en coefficients de transformation (2108) à des niveaux de résolution de fréquence successivement inférieurs et les retourne en échantillons de sous-bandes dans le domaine temporel (2114) à des échelles de temps successivement plus fines à des itérations successives ;
un codeur de tonalité (102) qui (a) extrait des composantes tonales (2109) des coefficients de transformation à chaque itération, les quantifie (2110) et les stocke dans une liste de tonalités (2106), (b) retire les composantes tonales (2111, 2112) du signal audio d'entrée pour passer un signal résiduel (2114b) à l'itération suivante du HFB et (c) classe toutes les composantes tonales extraites en fonction de leur contribution relative à la qualité du signal décodé ;
un codeur résiduel (107) qui applique une transformation inverse finale (2115) avec une résolution en fréquence relativement inférieure à celle de l'itération finale du HFB (2101e) au signal résiduel final (113) pour extraire les composantes résiduelles (2117, 2118, 2119) et classe les composantes résiduelles en fonction de leur contribution relative à la qualité de signal décodé ;
les composantes tonales extraites et les composantes résiduelles étant classées et quantifiées en référence à la même fonction de masquage ou à des critères psychoacoustiques différents ;
un formateur de train de bits (109) qui assemble les composantes tonales et résiduelles sur une base de trame par trame pour former un train de bits maître (126) ; et
un dispositif d'échelonnage (115) qui élimine un nombre suffisant des composantes codées les moins bien classées de chaque trame du train de bits maître pour former un train de bits échelonné (116) ayant un débit de données inférieur ou approximativement égal à un débit de données souhaité,
le train de bits échelonné comprenant des informations qui indiquent la position des composantes dans le spectre de fréquences.

**32.** Codeur selon la revendication 31, le codeur de tonalité regroupant les composantes tonales en sous-domaines de fréquence à différentes résolutions de fréquence (903, 904, 905, 906, 907) et classant les composantes avec chaque sous-domaine, le codeur résiduel regroupant les composantes résiduelles en sous-domaines résiduels à différentes échelles de temps et/ou résolutions de fréquence (908, 909, 910) et classant les composantes avec chaque sous-domaine et ledit formateur de train de bits classant les sous-domaines sur la base de leur contribution relative à une qualité du signal décodé.

33. Codeur selon la revendication 32, le formateur de train de bits ordonnant les sous-domaines et les composantes à l'intérieur de chaque sous-domaine sur la base de leur classement, ledit dispositif d'échelonnage (115) éliminant lesdites composantes de rang inférieur en commençant par la composante de rang le plus bas dans le sous-domaine de rang le plus bas et en éliminant les composantes dans l'ordre jusqu'à l'obtention du débit de données souhaité.

34. Codeur selon la revendication 31, le signal audio d'entrée étant un signal audio d'entrée multicanal, ledit codeur de tonalité codant conjointement chacune desdites composantes tonales en formant des groupes desdits canaux et pour chacun desdits groupes :

   la sélection d'un canal primaire et d'au moins un canal secondaire, qui sont identifiés par un masque de bits (3602), chaque bit identifiant la présence d'un canal secondaire ;
   la quantification et le codage du canal primaire (102, 108) ; et
   la quantification et le codage de la différence entre le canal primaire et chaque canal secondaire (102, 108) .

35. Codeur selon la revendication 31, le signal d'entrée étant un signal audio multicanal, ledit codeur résiduel formant les canaux du signal résiduel en groupes déterminés par des critères de perception et d'efficacité de codage (3702) ;
   déterminant des canaux primaires et secondaires pour chacun desdits groupes de signaux résiduels (3704) ;
   calculant une grille partielle (508) pour coder des informations spatiales relatives entre chaque paire de canaux primaire/secondaire dans chaque groupe de signaux résiduels (502) ;
   quantifiant et codant des composantes résiduelles pour le canal primaire dans chaque groupe en tant que grilles respectives G (2110a) ;
   quantifiant et codant la grille partielle pour réduire le débit de données requis (2110a) ; et
   insérant la grille partielle codée et la grille G pour chaque groupe dans le train de bits échelonné (3706).

36. Codeur selon la revendication 31, le codeur résiduel extrayant des composantes d'échantillon temporel représentées par une grille G (2117) et une série d'une ou plusieurs grilles de facteurs d'échelle G0, G1 (2118, 2119) à résolutions temporelles et fréquentielles multiples qui sont appliquées aux composantes d'échantillon temporel en divisant la grille G par des éléments de grille G0, G1 du plan temps/ fréquence (2120), chaque grille G0, G1 ayant un nombre différent de facteurs d'échelle en temps et/ou fréquences.

Fig. 1

EP 1 891 740 B1

Fig. 2a

Fig. 2b

Transform Coefficients

Subband Samples

2708

2806

2802

1

4

16

2804

64

2814

256

1024

2810

2812

4096

2800

Fig. 3

EP 1 891 740 B1

41

Buffer samples into Frames of N samples, Apply N-pt Window to each Frame — 2900

N-pt MDCT: produce N/2 sub-bands — 2902

Ringing Reduction (optional) — 2904

Divide into P groups of M coefficients. Apply P (2*M)-point IMDCTs to produce (2*M) samples from each group — 2906

Window — 2908

Overlap-Add — 2910

2912
Repeat on sub-bands

2914
N ← Desired frequency resolution? → Y

Done

Fig. 4

Fig. 5a

2702

Frame 1

Frame 2

Frame 3

2704

X

Fig. 5b

2706

Fig. 5c

2708

EP 1 891 740 B1

3300

5.5kHz        11kHz        22kHz

$10^0$

$10^{-5}$

200   400   600   800   1000   1200   1400   1600   1800   2000

# Fig. 6

Primary: Ch 3

| Channel | 0 | 1 | 2 | 4 | 5 | 6 |
|---------|---|---|---|---|---|---|
| Bit-mask | 0 | 1 | 0 | 1 | 1 | 0 |

3602

LSB           MSB

# Fig. 9

EP 1 891 740 B1

Fig. 7

EP 1 891 740 B1

128bins - 0..22050Hz          128(512)bins - 0..5512Hz          128(2048)bins - 0..1378Hz

3000

3004          3006          3010          3012          3016          3018

3002                [32x1]                    OutLo   [32x1]                    [128x1]
                OutLo                                              In    Out              3
                          In        OutHi                                              Out3
    In      OutHi   [96x1]              OutHi [96x1]        Analyse3
Data  [256x1]                      2
                              1      Out2
                          Out1                              Analyse2
                                              3014
                          Analyse1
                          3008

## Fig. 8a

3034          3042          3044          3046          3048          3050

3020    3022   3024   3026   3028   3030   3032

                                                      [32x1]              [84x1]              [84x1]    Frame overlap  [32x1]
    1    [32x1]        [256x1]  shmun  [256x1]  MDCT  [128x1]  Select        IMDCT        shmun                              1
    In              (fs,2,1.5)                        Rows                          (fs,2,1.5)                        OutLo
          Buffer      Window1                                [96x1]              Window2
                                                              2
                                                            OutHi
                                              Multiport      3037
                                              Selector

## Fig. 8b

Fig. 10

Fig. 11

Fig. 12

Fig. 13

EP 1 891 740 B1

Fig. 14

Fig. 15

EP 1 891 740 B1

4008

4010

MDCT

MDCT 4102

MDCT

MDCT

IMDCT

128

4012

+

4104

Synthesis coefficients

X

4106

Tonal component
Amplitude envelope

4102

Fig. 16

Fig. 17a

Fig. 17b

Fig. 18

| High Resolution Grid Sub-band | Grid 1 Sub-Band Number | | | | | | | | | | |
|---|---|---|---|---|---|---|---|---|---|---|---|
| | 0 | 1 | 2 | 3 | 4 | 5 | 6 | 7 | 8 | 9 | 10 |
| 0 | 1 | 0 | 0 | 0 | 0 | 0 | 0 | 0 | 0 | 0 | 0 |
| 1 | 0 | 1 | 0 | 0 | 0 | 0 | 0 | 0 | 0 | 0 | 0 |
| 2 | 0 | 0 | 1 | 0 | 0 | 0 | 0 | 0 | 0 | 0 | 0 |
| 3 | 0 | 0 | 0 | 1 | 0 | 0 | 0 | 0 | 0 | 0 | 0 |
| 4 | 0 | 0 | 0 | 0 | 0.5 | 0 | 0 | 0 | 0 | 0 | 0 |
| 5 | 0 | 0 | 0 | 0 | 0.5 | 0 | 0 | 0 | 0 | 0 | 0 |
| 6 | 0 | 0 | 0 | 0 | 0 | 0.5 | 0 | 0 | 0 | 0 | 0 |
| 7 | 0 | 0 | 0 | 0 | 0 | 0.33333 | 0.09524 | 0 | 0 | 0 | 0 |
| 8 | 0 | 0 | 0 | 0 | 0 | 0.16667 | 0.19048 | 0 | 0 | 0 | 0 |
| 9 | 0 | 0 | 0 | 0 | 0 | 0 | 0.28571 | 0 | 0 | 0 | 0 |
| 10 | 0 | 0 | 0 | 0 | 0 | 0 | 0.21429 | 0.05556 | 0 | 0 | 0 |
| 11 | 0 | 0 | 0 | 0 | 0 | 0 | 0.14286 | 0.11111 | 0 | 0 | 0 |
| 12 | 0 | 0 | 0 | 0 | 0 | 0 | 0.07143 | 0.16667 | 0 | 0 | 0 |
| 13 | 0 | 0 | 0 | 0 | 0 | 0 | 0 | 0.22222 | 0 | 0 | 0 |
| 14 | 0 | 0 | 0 | 0 | 0 | 0 | 0 | 0.17778 | 0.03636 | 0 | 0 |
| 15 | 0 | 0 | 0 | 0 | 0 | 0 | 0 | 0.13333 | 0.07273 | 0 | 0 |
| 16 | 0 | 0 | 0 | 0 | 0 | 0 | 0 | 0.08889 | 0.10909 | 0 | 0 |
| 17 | 0 | 0 | 0 | 0 | 0 | 0 | 0 | 0.04444 | 0.14545 | 0 | 0 |
| 18 | 0 | 0 | 0 | 0 | 0 | 0 | 0 | 0 | 0.18182 | 0 | 0 |
| 19 | 0 | 0 | 0 | 0 | 0 | 0 | 0 | 0 | 0.15152 | 0.02778 | 0 |
| 20 | 0 | 0 | 0 | 0 | 0 | 0 | 0 | 0 | 0.12121 | 0.05556 | 0 |
| 21 | 0 | 0 | 0 | 0 | 0 | 0 | 0 | 0 | 0.09091 | 0.08333 | 0 |
| 22 | 0 | 0 | 0 | 0 | 0 | 0 | 0 | 0 | 0.06061 | 0.11111 | 0 |
| 23 | 0 | 0 | 0 | 0 | 0 | 0 | 0 | 0 | 0.03030 | 0.13889 | 0 |
| 24 | 0 | 0 | 0 | 0 | 0 | 0 | 0 | 0 | 0 | 0.16667 | 0 |
| 25 | 0 | 0 | 0 | 0 | 0 | 0 | 0 | 0 | 0 | 0.13889 | 0 |
| 26 | 0 | 0 | 0 | 0 | 0 | 0 | 0 | 0 | 0 | 0.11111 | 0.05 |
| 27 | 0 | 0 | 0 | 0 | 0 | 0 | 0 | 0 | 0 | 0.08333 | 0.1 |
| 28 | 0 | 0 | 0 | 0 | 0 | 0 | 0 | 0 | 0 | 0.05556 | 0.15 |
| 29 | 0 | 0 | 0 | 0 | 0 | 0 | 0 | 0 | 0 | 0.02778 | 0.2 |
| 30 | 0 | 0 | 0 | 0 | 0 | 0 | 0 | 0 | 0 | 0 | 0.25 |
| 31 | 0 | 0 | 0 | 0 | 0 | 0 | 0 | 0 | 0 | 0 | 0.25 |

1900

Fig. 19

For Group 5:

| F_dlt | 0 | 1 | 2 | 3 | 4 |
|---|---|---|---|---|---|
| 0 | 0.01 | -0.0037 | -0.002 | -0.00694 | -0.00184 |
| 1 | 0.04167 | 0 | 0 | -0.02083 | -0.01235 |
| 2 | 0.125 | 0.0558 | 0.03307 | -0.01645 | -0.00975 |
| 3 | 0.15625 | 0.0625 | 0.03704 | -0.00625 | -0.0037 |
| 4 | 0.1996 | 0.07813 | 0.0463 | 0.00227 | 0.00135 |
| 5 | 0.2 | 0.0625 | 0.03704 | 0.02083 | 0.00741 |
| 6 | 0.21277 | 0.05556 | 0.03292 | 0.02083 | 0.01235 |
| 7 | 0.21739 | 0.04735 | 0.02806 | 0.03472 | 0.02058 |
| 8 | 0.21739 | 0.03472 | 0.02058 | 0.04735 | 0.02806 |
| 9 | 0.21277 | 0.02083 | 0.01235 | 0.05556 | 0.03292 |
| 10 | 0.2 | 0.02083 | 0.00741 | 0.0625 | 0.03704 |
| 11 | 0.1996 | 0.00227 | 0.00135 | 0.07813 | 0.0463 |
| 12 | 0.15625 | -0.00625 | -0.0037 | 0.0625 | 0.03704 |
| 13 | 0.125 | -0.01645 | -0.00975 | 0.0558 | 0.03307 |
| 14 | 0.04167 | -0.02083 | -0.01235 | 0 | 0 |
| 15 | 0.01 | -0.00694 | -0.00184 | -0.0037 | -0.002 |

2000

For Group 4:

| F_dlt | 0 | 1 | 2 | 3 | 4 |
|---|---|---|---|---|---|
| 0 | 0.005 | -0.02 | 0.0125 | -0.30303 | 0.002 |
| 1 | 0.10417 | 0.04 | -0.025 | 0.03333 | -0.02 |
| 2 | 0.125 | 0.01 | 0.01429 | -0.05 | -0.02 |
| 3 | 0.15625 | -0.00062 | -0.00049 | -0.00062 | -0.00049 |
| 4 | 0.15625 | -0.00062 | -0.00049 | -0.00062 | -0.00049 |
| 5 | 0.125 | -0.05 | -0.02 | 0.01 | 0.01429 |
| 6 | 0.10417 | 0.03333 | -0.02 | 0.04 | -0.025 |
| 7 | 0.005 | -0.30303 | 0.002 | -0.02 | 0.0125 |

## Fig. 20

For Group 3:

| F_dlt | 0 | 1 | 2 | 3 | 4 |
|---|---|---|---|---|---|
| 0 | 0.14286 | 0.125 | -0.02857 | -0.03571 | 0.02083 |
| 1 | 0.18182 | 0.05882 | 0.03333 | 0.02128 | 0.01 |
| 2 | 0.18182 | 0.02128 | 0.01 | 0.05882 | 0.03333 |
| 3 | 0.14286 | -0.03571 | 0.02083 | 0.125 | -0.02857 |

Fig. 21

Fig. 22

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020176353 A1

**Non-patent literature cited in the description**

- Hybrid representations for audiophonic signal encoding. **DAUDET L et al.** SIGNAL PROCESSING. ELSEVIER SCIENCE PUBLISHERS, 01 November 2002, vol. 82, 1595-1617

- **K. BRANDENBURG et al.** The ISO-MPEG-Audio Codec: A Generic Standard for Coding of High Quality Digital Audio. *Journal of Audio Engineering Society,* October 1994, vol. 42 (10